(19) Europäisches Patentamt
European Patent Office
Office européen des brevets

(11) **EP 2 905 627 B1**

(12) **EUROPÄISCHE PATENTSCHRIFT**

(45) Veröffentlichungstag und Bekanntmachung des Hinweises auf die Patenterteilung:
**26.10.2016 Patentblatt 2016/43**

(51) Int Cl.:
***G01R 15/18*** *(2006.01)*   ***G01R 19/00*** *(2006.01)*
***G01R 19/20*** *(2006.01)*   *G01R 19/25* *(2006.01)*

(21) Anmeldenummer: **15150631.8**

(22) Anmeldetag: **09.01.2015**

(54) **Vorrichtung und Verfahren zur kontaktlosen, präzisen Messung des Gleichstromanteils in einem Mischstrom**

Device and method for the contactless, precise measurement of the DC part in a mixed current

Dispositif et procédé de mesure précise sans contact de la part de courant continu dans un courant ondulatoire

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **06.02.2014 DE 102014101467**

(43) Veröffentlichungstag der Anmeldung:
**12.08.2015 Patentblatt 2015/33**

(73) Patentinhaber: **Hinke, Roland**
**63683 Ortenberg (DE)**

(72) Erfinder: **Hinke, Roland**
**63683 Ortenberg (DE)**

(74) Vertreter: **Staudt, Armin Walter**
**Sandeldamm 24a**
**63450 Hanau (DE)**

(56) Entgegenhaltungen:
**DE-A1- 3 940 932     DE-U1-202012 012 649**
**US-A1- 2012 038 360**

• **MIRSKY G: "LINEAR CURENT SENSOR", ELECTRONICS WORLD, NEXUS MEDIA COMMUNICATIONS, SWANLEY, KENT, GB, Bd. 99, Nr. 1688, 1. Juli 1993 (1993-07-01), Seite 596, XP000378447, ISSN: 0959-8332**

**Beschreibung**

Die vorliegende Erfindung betrifft eine Vorrichtung zur kontaktlosen Messung des Gleichstromanteils in einem Mischstrom eines Stromleiters, aufweisend eine Magnetkern-Sonde zur Erfassung des Wechselstromanteils und des Gleichstromanteils im Mischstrom, einen Oszillator zur Generierung eines Anregungssignals, sowie eine Kompensations-Einheit zur Erzeugung eines Kompensierstroms zur induktiven Kompensation des Wechselstromanteils in der Magnetkern-Sonde, wobei das Anregungssignal und der Kompensierstrom auf die Magnetkern-Sonde geführt sind.

Weiterhin betrifft die vorliegende Erfindung ein Verfahren zur kontaktlosen Messung des Gleichstromanteils in einem Mischstrom eines Stromleiters, umfassend die Verfahrensschritte:

(a) Generieren eines Anregungssignals für eine Magnetkern-Sonde,
(b) Erfassen des Wechselstromanteils und des Gleichstromanteils im Mischstrom mit der Magnetkern-Sonde,
(c) Erzeugen eines Kompensierstroms zur induktiven Kompensation des Wechselstromanteils in der Magnetkern-Sonde, und
(d) Ermitteln des Gleichstromanteils.

Vorrichtungen in diesem Sinne sind beispielsweise Digitalmultimeter, die zur Bestimmung elektrischer Messgrößen, beispielsweise zur Messung eines elektrischen Stroms, einer elektrischen Leistung oder Arbeit geeignet sind.

Stand der Technik

Herkömmliche Strommessgeräte müssen grundsätzlich in Reihe zum Verbraucher angeschlossen werden. Bei diesen Messgeräten ist es daher notwendig, zunächst eine Leitung oder ein Kabel des zu messenden Stromkreises aufzutrennen, um das Strommessgerät mit dem zu messenden Stromkreis verbinden zu können. Beispielsweise kann der Spannungsabfall über einem bekannten Messwiderstand ermittelt und so indirekt auf den Strom geschlossen werden. Es ist bekannt, dass ein Auftrennen des Stromkreises bei der Strommessung vermieden werden kann, wenn indirekte Messmethoden zur Strommessung eingesetzt werden. Es sind Strommessgeräte bekannt, die den stromführenden Leiter zangenförmig umschließen; sie werden auch als Zangenamperemeter oder Strommesszangen bezeichnet.

Dabei werden Strommesszangen unterschieden, die nur zur Messung von Wechselstrom (Wechselstrom-Messzangen) oder zur Messung von Wechselstrom oder Gleichstrom (Allstrom-Messzangen) geeignet sind.

Wechselstrom-Messzangen weisen in der Regel einen Eisenkern auf, der den stromführenden Leiter umschließt. Der Eisenkern ist ferner mit einer Wicklung versehen. Wechselstrom-Messzangen funktionieren nach dem Prinzip des Transformators. Der Eisenkern bildet den Transformator-Kern, die um den Kern angeordnete Wicklung die Sekundärwicklung und der zu messende Leiter die Primärwicklung. Aus dem in der Sekundärwicklung gemessenen Strom und dem Verhältnis der Windungszahlen der Primär- und der Sekundärwicklung kann auf den Strom im Leiter geschlossen werden.

Strommesszangen, die sowohl zur Messung von Gleichstrom als auch zur Messung von Wechselstrom eingesetzt werden, arbeiten nach dem Induktionsprinzip. Dabei werden ebenfalls Messsonden eingesetzt, die den elektrischen Leiter zangenförmig umschließen. Diese Messsonden enthalten einen Kern, beispielsweise einen Eisenkern, der einen Luftspalt aufweist. In dem Luftspalt ist ein Sensor zur Erfassung des Magnetfeldes, beispielsweise ein Hallsensor angeordnet, der das Magnetfeld in dem Eisenkern erfassen kann. Wird der Hallsensor senkrecht zum Magnetfeld des Eisenkerns von einem Strom durchflossen, liefert er eine Ausgangsspannung, die proportional zum Produkt aus magnetischer Feldstärke und Strom ist. Der Hallsensor liefert auch dann ein Signal, wenn das Magnetfeld konstant ist, beispielsweise bei der Messung eines Gleichstroms.

Allerdings zeigt das Kernmaterial bekannter Allstrom-Messzangen häufig ein verzögertes Systemverhalten (Hysterese) und eine Remanenz, durch die eine exakte Strommessung erschwert wird.

Um den Einfluss der Remanenz des Kernmaterials auf das Messergebnis zu verringern, wird daher in der US 2012/0038360 A1 eine Messsonde vorgeschlagen, die ein superparamagnetisches Kernmaterial aufweist. Superparamagnetismus tritt bei kleinen ferromagnetischen oder ferrimagnetischen Nanopartikeln auf, die unter Magnetisierung ihre Richtung ändern können. Das Kernmaterial der Messsonde aus US 2012/0038360 A1 umfasst eine feste Matrix, in die superparamagnetische Partikel, beispielsweise ferromagnetische Partikel mit geringer Teilchengröße von weniger als 20 nm, eingebettet sind. Superparamagnetische Partikel zeigen nach dem Abklingen eines externen Magnetfelds und dem Abwarten der Neel-Relaxationszeit keine erkennbare Magnetisierung. Um mit einer solchen Messsonde Gleichstrom messen zu können, werden die superparamagnetischen Partikel mit Hilfe eines alternierenden Magnetfelds angeregt. Hierdurch orientieren sich die Nanopartikel im Anregungsfeld, sodass eine harmonisch wechselnde Magnetisierung des Kernmaterials auftritt. Eine derartige Messsonde erfasst den Induktionsfluss im Takt des Anregungssignals und kann deshalb unter Ausnutzung ihres nichtlinearen Übertragungsverhaltens zur Messung eines Gleichstroms eingesetzt werden. Diese Messsonde ermöglicht, aufgrund fehlender Remanenz in der Hysteresekurve, die exakte Erfassung sowohl von Gleichstrom als auch von Wechselstrom.

Es hat sich allerdings gezeigt, dass der Einsatz derartiger Messsonden bei der Erfassung von Mischströmen, die sowohl einen Gleichstromanteil als auch einen Wechselstromanteil aufweisen zu Messungenauigkeiten führen kann.

Um dennoch eine Messung von Mischströmen mit einer hohen Genauigkeit zu ermöglichen, wird in der DE 10 2007 013 634 A1 vorgeschlagen, zwei Strommesswandler einzusetzen, wobei der erste Strommesswandler nur den Wechselstromanteil (nicht aber den Gleichstromanteil des Mischstroms) und der zweite Strommesswandler den gesamten Mischstrom (Gleichstromanteil und Wechselstromanteil) erfasst. Erster und zweiter Strommesswandler wirken dabei so zusammen, dass der vom ersten Strommesswandler erfasste Wechselstromanteil im zweiten Strommesswandler kompensiert wird, sodass der zweite Strommesswandler nur den Gleichstromanteil des Mischstroms erfasst.

Der gleichzeitige Einsatz von zwei Strommesswandlern ist allerdings aufwendig und geht mit einem gewissen Raumbedarf für die beiden Strommesswandler einher.

Darüber hinaus ist aus der DE 20 2012 012 649 U1 eine Vorrichtung zur Messung eines Wechselstromanteils in einem Mischstrom bekannt. Diese Vorrichtung ermöglicht eine hochgenaue Erfassung des Wechselstromanteils, eine Erfassung des Gleichstromanteils im Mischstrom ist mit dieser Vorrichtung allerdings nicht möglich.

Technische Aufgabenstellung

Der Erfindung liegt die Aufgabe zugrunde, eine Vorrichtung zur kontaktlosen Messung des Gleichstromanteils in einem Mischstrom anzugeben, die insbesondere auch bei gleichzeitigem Auftreten eines nicht sinusförmigen Wechselstromanteils eine hohe Messgenauigkeit aufweist.

Der Erfindung liegt ferner die Aufgabe zugrunde eine solche Vorrichtung anzugeben, die einen geringen Raumbedarf aufweist und darüber hinaus einfach und kostengünstig zu fertigen ist.

Weiterhin liegt der Erfindung die Aufgabe zugrunde, ein Verfahren zum kontaktlosen Messen des Gleichstromanteils eines Mischstroms anzugeben, das einfach durchzuführen ist.

Allgemeine Beschreibung der Erfindung

Hinsichtlich der Vorrichtung werden diese Aufgaben ausgehend von einer Vorrichtung der eingangs genannten Gattung erfindungsgemäß dadurch gelöst, dass eine Phasenregelschleife vorgesehen ist, die dazu eingerichtet ist, die Phasen des Anregungssignals und des Kompensierstroms mit der Phase des Wechselstromanteils im Mischstrom synchronisiert.

Die erfindungsgemäße Vorrichtung ist zur Aufnahme von Messignalen mit induktiven Stomwandlern geeignet; sie erlaubt die sehr genaue Messung des Gleichstromanteils in einem Mischstrom ohne direkten Kontakt zum Stromleiter.

Mischströme weisen neben einem Gleichstromanteil auch einen Wechselstromanteil auf. Gleichstromanteil und Wechselstromanteil können ähnlich hoch sein; in der Regel überwiegt jedoch einer der Anteile den anderen Anteil merklich. Das gleichzeitige Vorhandensein beider Stromanteile erschwert eine exakte Messung des Gleichstroms. Wechselstrom ist ein elektrischer Strom, der seine Größe und Richtung regelmäßig ändert. Er weist einen periodischen Verlauf auf und kann einem sinusförmigen Verlauf entsprechen oder von diesem abweichen.

Gemäß der Erfindung wird zur kontaktlosen Messung des Gleichstromanteils ein induktiver Stromwandler in Form einer Magnetkern-Sonde eingesetzt, die mit dem alternierenden Magnetfeld eines intern generierten Anregungssignals arbeitet und grundsätzlich ein nichtlineares Übertragungsverhalten aufweist. Eine solche Magnetkern-Sonde erfasst den gesamten Mischstrom umfassend einen Gleichstromanteil und einen Wechselstromanteil. Es hat sich gezeigt, dass einerseits die Messgenauigkeit gesteigert werden kann, wenn die Phase des additiven Anregungssignals mit der (vom Stromversorgungsnetz vorgegebenen) Phase des Wechselstromanteils synchronisiert wird. Andererseits wird nachfolgend gezeigt, dass auch das Vorsehen einer synchronisierten induktiven Kompensation des Wechselstroms in der Magnetkern-Sonde die Messgenauigkeit erhöht.

Durch die Synchronisierung der Phasen des Anregungssignals und des Kompensationssignals mit der Phase des Wechselstromanteils wird erreicht, dass das Anregungssignal und das Kompensationssignal frequenz- und phasenrichtig mit dem Wechselstromsignal übereinstimmen. Hierdurch wird eine hochgenaue Auswertung des Stromsensor-Messignals ermöglicht. Insbesondere trägt die Synchronisierung dazu bei, die bei der Signalumsetzung im Stromsensor entstehenden unerwünschten Mischprodukte und dadurch verursachte Messfehler zu minimieren.

Die erfindungsgemäße Vorrichtung weist zu den vorgenannten Zwecken eine Phasenregelschleife auf.

Eine Phasenregelschleife - im Folgenden auch als *"PLL"* bezeichnet von engl. phaselocked loop - ist eine elektronische Schaltungsanordnung, die einen Phasendetektor, ein Schleifenfilter, einen Integrator und einen steuerbaren Oszillator umfasst. Am Phasendetektor liegt vorzugsweise das Wechselspannungssignal des Stromleiters als äußeres Referenzsignal an. Der Phasendetektor vergleicht die Phasenlage des Referenzsignals mit der des steuerbaren Oszillators und regelt Phasenlage und Frequenz des veränderbaren Oszillators derart, dass diese dem Referenzsignal nachgeführt werden. Das von der Phasenregelschleife erzeugte Oszillatorsignal ist nach einem Einschwingvorgang mit dem äußeren Referenzsignal (beispielsweise der Netzspannung) phasenstarr synchronisiert; dies gilt auch für zwei zusätzliche, parallel angesteuerte Oszillatoren, die ein Abtastsignal und ein harmonisches Anregungssignal synthetisieren, wobei der *SAMPLE*-Oszillator *M* Abtastzeitpunkte pro Netzperiode erzeugt und der *CARRY*-Oszillator mit *N*-facher Netzfrequenz $f_{AC}$ oszilliert, sodass jede Anregungsperiode *M/N* Abtastzeitpunkte aufweist.

Unter einer Netzperiode *1/f_{AC}* versteht man das zeitlich kleinste sich wiederholende Intervall des Wechselstromverlaufs, das dem Kehrwert der Netzfrequenz entspricht.

Da nicht gewährleistet ist, dass das Messobjekt (der Stromleiter) immer Strom führt, ist die Phasenregelschleife zur Detektion der einzelnen Netzperioden vorzugsweise in einem Spannungskanal der erfindungsgemäßen Vorrichtung angeordnet. In einer alternativen Ausführungsform könnte die Phasenregelschleife auch in einem Stromkanal zur Erfassung des Wechselstroms liegen.

Die Phasenregelschleife ermittelt aufeinanderfolgende Netzperioden (Wechselstromperioden) und der *CARRY*-Oszillator unterteilt jede Wechselstromperiode in eine ganzzahlige Anzahl *N* von Anregungsperioden, sodass das Anregungssignal mit dem Wechselstromanteil im Stromleiter phasenstarr synchronisiert ist und bei der Signalumsetzung in der Magnetkern-Sonde keine unerwünschten Mischprodukte entstehen, welche die Messgenauigkeit der Vorrichtung einschränken können.

Diese Phasenregelschleife bildet die netzsynchrone Zeitbasis und ermöglicht neben der Generierung des netzphasensynchronen Anregungssignals auch die netzperiodengestützte Erfassung des Wechselstromanteils, dessen Magnetfeld erfindungsgemäß in der Magnetkern-Sonde zu kompensieren ist. Dazu wird in der Messvorrichtung ein Kompensierstrom (Hilfssignal) erzeugt, dessen Magnetfeld als Kompensationsfeld wirkt, das den Wechselstromanteil im Magnetkern der Sonde möglichst vollständig kompensiert.

Auch die Synchronisierung des Kompensierstroms mit der Phase des Wechselstromanteils trägt dazu bei, dass die Messgenauigkeit gesteigert werden kann. Somit ist eine hochgenaue Bestimmung des Gleichstromanteils im Mischstrom eines isolierten Stromleiters möglich.

Die Magnetkern-Sonde erzeugt regelmäßig ein Magnetkern-Sondensignal, wobei zur Auswertung des Magnetkern-Sondensignals eine Demodulator-Einheit vorgesehen ist. Die Magnetkern-Sonde erfasst sowohl den Gleichstrom- als auch den Wechselstromanteil des Mischstroms. Durch den Einsatz einer Demodulator-Einheit kann der Gleichstromanteil des Stromsignals vom restlichen Signal getrennt und dabei regeneriert werden.

Im Falle von reinem Gleichstrom im Stromleiter wird der Induktionsfluss im Spulenkern der Magnetkern-Sonde nur vom Gleichstrom im Stromleiter und vom intern erzeugten Anregungssignal in der Magnetisierungsspule gebildet. Das statische Magnetfeld des Gleichstroms und das alternierende Magnetfeld des Anregungssignals überlagern sich und generieren im magnetisierbaren Spulenkern einen entsprechenden Induktionsfluss, der eine Signalspannung in der Magnetkern-Messspule induziert. Die Messgröße für den Gleichstromanteil im Stromleiter kann in der Demodulator-Einheit aus einer der Spektrallinien dieses Magnetkern-Sondensignals gewonnen werden, die aufgrund der nichtlinearen Magnetisierungskurve des Kernmaterials auf der ersten Oberwelle und auf allen geradzahlig Harmonischen des Anregungssignals liegen. Schließlich kann die Messgröße durch **D**iskrete **F**ourier-**T**ransformation aus dem zeitdiskreten Magnetkern-Sondensignal bestimmt und mit Korrekturfaktoren aus einer Linearisierungstabelle gewichtet werden, die das nichtlineare Übertragungsverhalten der Magnetkern-Sonde abbildet.

Es hat sich bewährt, wenn zur Linearisierung des Magnetkern-Sondensignals ein Kalibrier-Modul zur Kalibrierung der Magnetkern-Sonde unter Zugrundelegung einer Linearisierungskurve vorgesehen ist.

Die Kalibrierung der Magnetkern-Sonde kann durch einen Algorithmus oder durch empirische Ermittlung von Stützstellen einer Linearisierungskurve erfolgen. Insbesondere die Ermittlung von Stützstellen ermöglicht eine einfache Kalibrierung. Hier hat sich der Einsatz einer Linearisierungstabelle als vorteilhaft erwiesen.

In einer solchen Linearisierungstabelle sind Korrekturfaktoren für diskrete Messergebnisse (Stützstellen) aus dem gesamten Messbereich gespeichert. Die empirische Feststellung dieser Stützstellen erfolgt mit Hilfe einer automatisierten Kalibrierprozedur, die im Kalibriermodus der Messvorrichtung jederzeit durchgeführt werden kann. Dabei erzeugt ein integrierter Testsignalgenerator die in der Linearisierungstabelle vordefinierten Gleichstrompegel und speist diese nacheinander in die Magnetisierungsspule der Magnetkern-Sonde ein, sodass sich für jeden Gleichstrompegel am Ausgang des DFT-Kanals ein Messwert und damit ein aktueller Korrekturfaktor der Linearisierungstabelle ergeben.

Im normalen Betriebsmodus der Messvorrichtung wird jeder Messwert (Gleichstrompegel) am Ausgang des DFT-Kanals mit dem zugeordneten Korrekturfaktor aus der Linearisierungstabelle gewichtet. Dies bewirkt die Linearisierung der Messstrecke und ermöglicht die sehr genaue Bestimmung des Gleichstromanteils im Mischstrom eines isolierten Stromleiters.

Bei einer bevorzugten ersten Ausgestaltung der erfindungsgemäßen Vorrichtung ist zur Erfassung des Wechselstromanteils im Mischstrom eine Rogowski-Sonde mit einer mehrstufigen Filter-und Integrator-Einheit vorgesehen, die über die Phasenregelschleife mit der Phase des Wechselstromanteils im Mischstrom synchronisiert ist. Das Ausgangssignal dieser Filter- und Integrator-Einheit bildet den Kompensierstrom in der Magnetkern-Sonde.

Für die exakte Erfassung des Wechselstromanteils im Mischstrom wird eine Rogowski-Sonde eingesetzt, die eine toroidförmige Spule mit einem Luftkern und zwei Spulen-Enden aufweist. Sie kann für Messzwecke einfach geöffnet werden, da in der Regel die Zuleitung eines der Spulen-Enden durch die Mitte der Spule zum anderen Spulen-Ende zurückgeführt ist. Damit wird eine einfache und schnell vor Ort durchführbare Messung des Wechselstromanteils ermöglicht. Insbesondere kann durch den Einsatz einer Rogowski-Sonde eine kontaktlose Messung auch in einem beengten Bauraum durchgeführt werden.

Eine um einen Mischstrom führenden Stromleiter angeordnete Rogowski-Sonde liefert ein Rogowski-Sondensignal $r_{AC}(t)$ beziehungsweise $r_{AC}(n)$, das zum Differential des Leiterstroms proportional ist. Da Rogowski-Sonden eine sehr niedrige Induktivität aufweisen, sind sie insbesondere zur Erfassung sich schnell verändernder Ströme geeignet. Ein gleichzeitig im Leiter vorhandener Gleichstromanteil wird idealerweise von einer Rogowski-Sonde nicht erfasst. Um aus dem Rogowski-Sondensignal eine dem Leiterstrom proportionale Größe zu erhalten, ist es notwendig, das Rogowski-Sondensignal zu integrieren.

Da in der Praxis dem Rogowski-Sondensignal schaltungsbedingt ein Gleichanteil aufgeprägt sein kann und im integrierten Rogowski-Sondensignal signalbedingt ein weiterer Gleichanteil entstehen kann, wobei beide Gleichanteile das Messergebnis verfälschen, ist der exakte Wechselstromanteil nur dann zu bestimmen, wenn diese nicht erwünschten Gleichanteile im Integrator festgestellt und eliminiert werden, vorzugsweise für jede einzelne Netzperiode.

Zu diesem Zweck ist eine spezielle mehrstufige Filter- und Integrator-Einheit vorgesehen, die sowohl eine Eingangssignal-Korrektur für das Rogowski-Sondensignal $r_{AC}(n)$ als auch eine Ausgangssignal-Korrektur für das Wechselstromsignal $i_{AC}(n)$ durchführt.

Es hat sich bewährt, wenn der Wechselstromanteil netzperiodengestützt, das heißt bezogen auf eine oder mehrere Netzperioden ermittelt wird. Vorzugsweise wird die Filter-und Integrator-Einheit mit Steuersignalen aus einer Phasenregelschleife auf die Netzperioden synchronisiert.

Eine vorteilhafte Ausgestaltung der erfindungsgemäßen Vorrichtung sieht vor, dass die digitale Phasenregelschleife (neben der Generierung des netzphasensynchronen Anregungssignals) für jede zu messende Netzperiode einen Unterabtastzeitpunkt $p$ festlegt, und dass dieser im Steuersignal $d(n)$ bereitgestellte Parameter zur Unterabtastung des Gleichstromsignals $i^0 DC(n)$ verwendet wird.

Der Vorrichtung liegt mit den netzgeführten Oszillatoren der Phasenregelschleife ein Signalverarbeitungsalgorithmus zugrunde, der als Multiratensystem mit einer im *SAMPLE*-Oszillator festgelegten Anzahl ($M = Netzperiode/Abtastperiode$) von Abtastzeitpunkten n und einem Unterabtastzeitpunkt $p$ pro Netzperiode arbeitet.

Der Unterabtastzeitpunkt p entspricht dem letzten Abtastzeitpunkt n einer detektierten Signalperiode des Referenzsignals. Vorzugsweise ist ein Unterabtastzeitpunkt p der Zeitpunkt des positiven Nulldurchgangs, beispielsweise einer sinusförmigen Signalperiode.

Die von der Phasenregelschleife generierten Steuerparameter $ph(n)$ und $d(n)$ ermöglichen eine synchrone Auswertung aller von der erfindungsgemäßen Vorrichtung erfassten Messsignale.

Wird der im Mischstrom enthaltene Wechselstromanteil über eine Rogowski-Sonde mit Hilfe einer netzperiodengestützten Filter- und Integrator-Einheit hochgenau ermittelt, so ist die vollständige Kompensation des Wechselstromfelds in der Magnetkern-Sonde möglich. Beispielsweise kann die Magnetkern-Sonde mit einer Magnetisierungsspule versehen sein, durch die ein Kompensierstrom fließt, dessen Magnetfeld das vom Leiterstrom verursachte Wechselstromfeld im Spulenkörper kompensiert. Durch diese Maßnahme erfasst die Magnetkern-Sonde nur den im Mischstrom enthaltenen Gleichstromanteil, sodass dieser unabhängig vom Wechselstromanteil sehr genau bestimmt werden kann.

Bei einer bevorzugten Ausgestaltung der Filter- und Integrator-Einheit erfolgt die Eingangssignal-Korrektur bezogen auf eine einzelne Netzperiode. Hierzu wird der Gleichanteil des Rogowski-Sondensignals für die Netzperiode ermittelt und vom Rogowski-Sondensignal dieser Netzperiode subtrahiert. Für die Ausgangssignal-Korrektur wird angenommen, dass sich der Gleichanteil zweier aufeinanderfolgender Netzperioden nicht wesentlich unterscheidet, sodass der im Ausgangssignal für die vorangegangene Netzperiode ermittelte Gleichanteil von dem Ausgangssignal der Netzperiode subtrahiert werden kann. Hierdurch wird eine hohe Messgenauigkeit erzielt.

Bei einer anderen, ebenso bevorzugten Ausgestaltung der Filter- und Integrator-Einheit wird der Gleichanteil des Rogowski-Sondensignals für eine Netzperiode ermittelt. Dieser wird vom Rogowski-Sondensignal der Netzperiode abgezogen, sodass ein vom Gleichanteil befreiter Rogowski-Sondensignalwert $r_{AC}(n-M)$ erhalten wird. Hierzu ist es notwendig, die Netzperiode (M Abtastwerte) verzögert an den Integrator zu übergeben. Schließlich wird auch der Gleichanteil des integrierten Rogowski-Sondensignals für die verzögerte Netzperiode ermittelt und der Integrationswert (um eine weitere Netzperiode verzögert) von diesem Gleichanteil befreit als Wechselstromsignalwert $i_{AC}(n-2M)$ ausgegeben.

Hierdurch wird ein Wechselstromsignalwert erhalten, der auf eine einzige Netzperiode bezogen ist. Ein solcher Wechselstromsignalwert weist eine besonders hohe Messgenauigkeit auf.

Es hat sich als günstig erwiesen, wenn ein Signalgenerator zur Erzeugung eines Testsignals vorgesehen ist, und wenn die Rogowski-Sonde neben einer Messspule eine Testspule zur Einspeisung des Testsignals aufweist.

Um (unabhängig von einer werksseitig durchgeführten Kalibrierung der Messvorrichtung) eine exakte Kompensation des wechselstrombedingten Induktionsflusses in der Magnetkern-Sonde durch den von der Rogowski-Sonde erfassten Wechselstrom zu ermöglichen, ist die Rogowski-Sonde durch eine Testspule erweitert, sodass der Übertragungsfaktor für den Kompensierstrom im Kalibriermodus der Messvorrichtung aktualisiert werden kann.

Zur einfacheren Handhabung können die beiden Sonden (Rogowski-Sonde und Magnetkern-Sonde) parallel angeordnet und zu einem Messring zusammengefasst sein, der den Stromleiter wie eine einfache Rogowski-Sonde umschließen kann.

Hierdurch wird ein einfaches Anbringen der Messkern-Sonde am Messobjekt (dem Stromleiter) ermöglicht, und zwar insbesondere auch dann, wenn der hierfür zur Verfügung stehende Bauraum gering ist.

Bei einer alternativen, ebenso bevorzugten Vorrichtung zur kontaktlosen Messung des Gleichstromanteils im Mischstrom eines Stromleiters weist die Demodulator-Einheit einen ersten Signalverarbeitungspfad zur Demodulation des Gleichstromanteils und einen zweiten Signalverarbeitungspfad für die Gewinnung des Wechselstromanteils aus dem Mischstrom auf.

Eine solche Vorrichtung, die mit vielen Anregungsperioden pro Wechselstromperiode (N>>1) arbeitet, kommt mit nur einer Sonde zur gleichzeitigen Erfassung beider Anteile des Mischstroms aus. Das heißt, diese Vorrichtung wird nicht von einer unabhängigen Sonde mit einem Messwert für den Wechselstromanteil im Induktionsfluss der Magnetkern-Sonde unterstützt. Statt dessen kann aus dem Demodulations-Ergebnis für den Wechselstromanteil ein Kompensierstrom generiert und dieser auf die Magnetisierungsspule der Magnetkern-Sonde zurückgeführt werden, sodass über den Induktionfluss in der Magnetkern-Sonde ein geschlossener Regelkreis entsteht, mit dem jedoch nur eine teilweise Unterdrückung (Dämpfung) des nicht erwünschten Wechselstromanteils im Induktionsfluss der Sonde möglich ist.

Um mit dieser Vorrichtung die harmonischen Signalkomponenten eines nicht sinusförmigen Wechselstromanteils ausreichend unterdrücken (ausfiltern) zu können, ist ein entsprechend großer Frequenzabstand zwischen der Anregungssignal-Frequenz und der Wechselstrom-Frequenz erforderlich.

Durch den Verzicht auf eine zweite Sonde wird eine kompakte Vorrichtung erhalten, die eine schnelle und einfache Messung bei insgesamt ausreichender, bei reinem Gleichstrom sogar sehr hoher Messgenauigkeit ermöglicht und auch auf engem Raum verwendet werden kann.

In diesem Zusammenhang hat es sich bewährt, wenn die Magnetkern-Sonde eine Magnetisierungsspule zur Einspeisung des Anregungssignals und des Kompensierstroms aufweist.

Für eine sichere Erfassung von Gleichstromanteilen mit der Magnetkern-Sonde ist es vorteilhaft, wenn der Sondenkern eine Magnetisierungsspule (Primärwicklung) aufweist, die sowohl zum Aufprägen des harmonisch wechselnden Anregungsfelds, als auch zur Aufhebung des (vom Wechselstromanteil des Stromleiters verursachten) Wechselstromfelds dient.

Der Einsatz nur einer Magnetisierungsspule zum Aufprägen des Anregungsfelds und zum Einspeisen des Kompensierstroms oder des Kalibrierstroms (Testsignal) trägt zu einer kompakten Bauform der Magnetkern-Sonde und damit der Vorrichtung bei.

Es hat sich als günstig erwiesen, wenn die Magnetkern-Sonde einen zu einem flexiblen Messring formbaren Spulenkörper aus einem superparamagnetischen Material aufweist.

Die Erfassung des Mischstroms mittels einer Magnetkern-Sonde mit einem superparamagnetischen Kern trägt zu einer einfachen und exakten Messung des Gleichstromanteils bei. Derartige Magnetkern-Sonden zeichnen sich durch eine hohe Messgenauigkeit über einen großen Stromstärkenbereich aus; sie besitzen eine geringe magnetische Permeabilität, kaum magnetische Remanenz und ein geringes Gewicht. Das Fehlen von Remanenz macht häufige Kalibrierungen überflüssig und erlaubt schnelle und leicht durchführbare Messungen.

Magnetkern-Sonden mit einem superparamagnetischen Kern sind einerseits zur gleichzeitigen Erfassung von Gleichstrom und Wechselstrom geeignet. Sie liefern über einen großen Messbereich reproduzierbare, genaue Ergebnisse. Ein formbarer Spulenkörper kann andererseits einfach an das Messobjekt (den Stromleiter) angelegt werden.

Der superparamagnetische Kern einer Magnetkern-Sonde zeigt in Abwesenheit eines externen Magnetfelds (vorausgesetzt die Messzeit ist größer als die Neel-Relaxationszeit) keine erkennbare Magnetisierung. Um mit einer solchen Messsonde Gleichstrom messen zu können, wird das statische Magnetfeld des Gleichstroms von einem harmonisch wechselnden Anregungsmagnetfeld überlagert und an der nichtlinearen Übertragungskennlinie des superparamagnetischen Kernmaterials gespiegelt. Das statische Magnetfeld bestimmt dabei den Arbeitspunkt auf der Kennlinie, sodass der primärseitige Gleichstrom auf geradzahligen harmonischen Spektrallinien des Anregungssignals im Induktionsfluss abgebildet wird. So beschreibt beispielsweise die zweite harmonische Spektrallinie den Gleichstrom, der im Messobjekt (auf der Primärseite der Magnetkern-Sonde) fließt und sekundärseitig als Differentialquotient des Induktionsflusses im Takt des Anregungssignals abgegriffen werden kann.

Es hat sich bewährt, wenn zur Erfassung des Induktionsflusses in der Magnetkern-Sonde eine Magnetkern-Messspule vorgesehen ist.

Eine Magnetkern-Messspule auf dem toroidförmigen Magnetkern differenziert den in diesem Kern auftretenden Induktionsfluss. Das Ausgangssignal dieser Magnetkern-Messspule wird über einen DFT-Kanal auf der zweiten Harmonischen des Anregungssignals demoduliert, sodass der Gleichstromanteil des Mischstroms mit einem netzperiodensynchronen Mittelwertfilter bestimmbar ist.

Die Magnetkern-Messspule (Sekundärwicklung) umfasst die Magnetkern-Sonde vorzugsweise derart, dass

6

diese wie eine Rogowski-Sonde zu Messzwecken geöffnet werden kann.

Es hat sich bewährt, wenn zur Extraktion des Gleichstromanteils ein signal-angepasstes Mittelwertfilter vorgesehen ist.

Signal-angepasste Filter werden in der Literatur auch als "matched filter" oder Korrelationsfilter bezeichnet. Das signal-angepasste Mittelwertfilters ist so gewählt, dass dessen Filterlänge auf die Wechselstromperioden (Netzperioden) im Mischstrom abgestimmt ist. Der Einsatz eines netzperiodensynchronen Mittelwertfilters gewährleistet eine gute Trennung des Gleichstromanteils von den netzfrequenten Signalkomponenten, die ein nicht sinusförmiger Wechselstromanteil aufweist. Dadurch, dass die Demodulation des Gleichstromanteils netzperiodensynchron erfolgt, wird eine hohe Messgenauigkeit erreicht.

Es hat sich bewährt, wenn das Anregungssignal eine Anregungssignal-Frequenz und der Wechselstromanteil eine Wechselstrom-Frequenz aufweist, und wenn die Anregungssignal-Frequenz einem ganzzahlig Vielfachen der Wechselstrom-Frequenz entspricht, wobei vorzugsweise die Anregungssignal-Frequenz der Wechselstrom-Frequenz entspricht.

Ein solches Anregungssignal für den superparamagnetischen Kern wird beispielsweise von einem Oszillator erzeugt. Vorzugsweise liegt die Anregungssignal-Frequenz im Bereich des 1- bis 256-fachen der Wechselstrom-Frequenz.

Bei der erfindungsgemäßen Vorrichtung kann die Frequenz des Anregungssignals grundsätzlich beliebig gewählt werden. Um die Entstehung störender Mischprodukte bei der Signalumsetzung in der Magnetkern-Sonde zu verringern, wird die Anregungssignal-Frequenz allerdings so gewählt, dass sie einem ganzzahligen Vielfachen der Wechselstrom-Frequenz entspricht. Es hat sich besonders bewährt, wenn die Anregungssignal-Frequenz direkt der Wechselstrom-Frequenz entspricht. Hierdurch wird einerseits die Einspeisung hochfrequenter Signale vermieden, die als Störsignale eine exakte Messung des Gleichstromanteils erschweren könnten. Andererseits muss das superparamagnetische Kernmaterial der Magnetkern-Sonde bei einer geringeren Anregungssignal-Frequenz geringeren Materialanforderungen genügen, sodass damit auch Kernmaterial mit einer höheren Trägheit der superparamagnetischen Partikel zur exakten Bestimmung des Gleichstromanteils eingesetzt werden kann.

Hinsichtlich des Verfahrens zur kontaktlosen, präzisen Messung des Gleichstromanteils in einem Mischstrom wird die oben genannte Aufgabe ausgehend von einem Verfahren der eingangs genannten Gattung erfindungsgemäß dadurch gelöst, dass die Phasen des Anregungssignals und des Kompensierstroms mit der Phase des Wechselstromanteils im Mischstrom über eine Phasenregelschleife synchronisiert werden.

Das erfindungsgemäße Verfahren ermöglicht eine sehr genaue Messung des Gleichstromanteils eines Mischstroms, der durch einen isolierten, von einem Messring umschließbaren Stromleiter fließt. Hierzu stellt ein Oszillator ein netzphasensynchrones Anregungssignal für eine harmonisch wechselnde Magnetisierung des Kernmaterials einer Magnetkern-Sonde zur Verfügung. Das Magnetfeld des Anregungssignals induziert in der Magnetkern-Messspule dieser Magnetkern-Sonde eine Spannung, die aufgrund der nichtlinearen Magnetisierungskurve des Kernmaterials nicht nur den Wechselstromanteil sondern auch den Gleichstromanteil des Mischstroms umfasst.

Ferner ist eine Phasenregelschleife vorgesehen, die die Generierung eines netzphasensynchronen Anregungssignals für die Magnetkern-Sonde ermöglicht. Die Synchronisierung des Anregungssignals trägt insbesondere dazu bei, nicht erwünschte Mischprodukte (die bei der Signalumsetzung in der Magnetkern-Sonde entstehen können) und dadurch verursachte Messfehler zu minimieren.

Bei einem bewährten Verfahren zur Dimensionierung der digitalen Phasenregelschleife werden deren Komponenten Schleifenfilter und Integrator sowohl für den analogen als auch für den diskreten Bereich definiert. Beispielsweise wird der Integrator als Forward-Integrator im z-Bereich und der Schleifenfilter als Verzögerungsglied erster Ordnung im s-Bereich vorgegeben:

$$H_{Filter}(s) \ = \ K \, / \, (\, 1 + s \,) \qquad \leftrightarrow \qquad H_{Filter}(z^{-1}) \ = \ \boldsymbol{b} \, (\, 1 + z^{-1} \,) \, / \, (\, 1 + \boldsymbol{c} * z^{-1} \,) \, ,$$

$$H_{Integrator}(s) \ = \ (\, L - s \,) \, / \, (\, 2\,s \,) \qquad \leftrightarrow \qquad H_{Integrator}(z^{-1}) \ = \ z^{-1} \, / \, (\, 1 - z^{-1} \,) \, .$$

Zusammen mit dem Phasendetektor resultiert hieraus eine Phasenregelschleife zweiter Ordnung die im s-Bereich dimensioniert werden kann.

Den Zusammenhang zwischen der s-Ebene und der z-Ebene zeigen folgende Substitutionen:

$$s \ = \ L \, (\, z - 1 \,) \, / \, (\, z + 1 \,) \qquad \leftrightarrow \qquad z \ = \ (\, L + s \,) \, / \, (\, L - s \,) \, .$$

Der Einsatz von z = *exp (j w),* Abtastkreisfrequenz $w_a$ und Eigenkreisfrequenz $w_n$ führt zum Transformations-parameter $L = w/w_n$ / $tan(\pi w_n/w_a)$.

Indem die einzelnen Komponenten der *PLL* zu einer Regelschleife gekoppelt werden, bildet sich im Nenner der Übertragungsfunktion $H_{PLL}(s)$ eine quadratische Funktion von s.

$$H_{PLL}(s) = ( H_{Filter}(s) * H_{Integrator}(s) ) / ( 1 + H_{Filter}(s) * H_{Integrator}(s) ),$$

$$H_{PLL}(s) = ( - s*K/2 + L*K*/2 ) / ( s*s + 2*s*( 1/2 - K ) + L*K/2 ).$$

Mit dem Parameter Schwingkreisdämpfung *D* kann das Regelverhalten der Phasenregelschleife bestimmt und die Normalform der quadratischen Gleichung im Nennerpolynom $s*s + 2*s*D*w_n + w_n*w_n$ gelöst werden:

$$X = 4*L*D*D + 2,$$

$$K = X - \sqrt{( X*X - 4 )}.$$

Die Anwendung der Substitutionsgleichung in der Übertragungsfunktion $H_{Filter}(s)$ und das Ergebnis aus der quadratischen Gleichung führen schließlich auf die Koeffizienten **b** und **c** des Schleifenfilters.

$$H_{Filter}(z^{-1}) = \textbf{K/(L+1)} ( 1 + z^{-1} ) / ( 1 + \textbf{(1-L)/(1+L)} z^{-1} )$$

Bei einer ersten Variante des erfindungsgemäßen Messverfahrens ist vorgesehen, dass der Wechselstromanteil und der Gleichstromanteil mittels einer Magnetkern-Sonde mit einem superparamagnetischen Kern erfasst wird, und dass nach dem Erfassen des Wechselstromanteils und des Gleichstromanteils gemäß Verfahrensschritt (b) in einem ersten Signalverarbeitungspfad einer Demodulator-Einheit der Gleichstromanteil und in einem zweiten Signalverarbeitungspfad der Demodulator-Einheit der Wechselstromanteil gewonnen wird.

Dieses besonders einfache Verfahren ermöglicht die Messung des Gleichstromanteils mit einer einzigen Messsonde.

Bei einer zweiten Variante des erfindungsgemäßen Messverfahrens ist vorgesehen, dass der Gleichstromanteil mittels einer Magnetkern-Sonde mit einem superparamagnetischen Kern erfasst wird, und dass der Wechselstromanteil mittels einer Rogowski-Sonde mit einer mehrstufigen Filter- und Integrator-Einheit erfasst wird, die über die Phasenregelschleife mit der Phase des Wechselstromanteils im Mischstrom synchronisiert ist, wobei die Filter- und Integrator-Einheit als Ausgangssignal den Kompensierstrom erzeugt.

Um nur den Gleichstromanteil erfassen zu können, ist eine vollständige Kompensation des Induktionsflusses in der Magnetkern-Sonde, den der Wechselstromanteil des Mischstroms im Stromleiter verursacht, notwendig. Hierzu wird eine zweite (unabhängige) Sonde benötigt, die den Wechselstromanteil sehr genau bestimmt.

Wechselstrom kann mit einer Rogowski-Sonde hochgenau erfasst werden. Der Wechselstromanteil im Mischstrom des Stromleiters ist mit einer Rogowski-Sonde besonders exakt zu bestimmen, wenn signal- oder schaltungsbedingte Gleichanteile im Rogowski-Sondensignal bei der Integration für jede einzelne Wechselstromperiode festgestellt und eliminiert werden.

Erfindungsgemäß wird aus dem ermittelten Wechselstromsignal ein Kompensierstrom generiert, der schließlich den Wechselstromanteil im Induktionsfluss der Magnetkern-Sonde kompensiert.

Der Kompensierstrom fließt durch die Magnetisierungsspule der Magnetkern-Sonde, sodass für den wechselstrombedingten Induktionsfluss im superparamagnetischen Kern der Magnetkern-Sonde eine Gegenkopplung entsteht.

Bei einem bevorzugten erfindungsgemäßen Messverfahren wird zur Korrektur des nichtlinearen Magnetkern-Sondensignals eine Linearisierungskurve eingesetzt, die durch Ermittlung von Stützstellen und gegebenenfalls nachfolgender Interpolation gewonnen ist.

Aus dem verbleibenden Gleichstromanteil und dem harmonischen Anregungssignal entstehen im Induktionsfluss des superparamagnetischen Kerns auf den geradzahlig Harmonischen des Anregungssignals informationstragende Signalkomponenten. Die in der sekundärseitigen Magnetkern-Messspule induzierte Spannung kann in der Demodulator-Einheit beispielsweise auf der zweiten Harmonischen des Anregungssignals mit einem DFT-Kanal analysiert werden, sodass das Analyseergebnis mit Hilfe von Korrekturfaktoren aus einer Linearisierungstabelle zu einem sehr genauen Messwert für den Gleichstromanteil im Mischstrom des vom Messring umschlossenen Stromleiters führt.

Zur Linearisierung der Analyseergebnisse wird ein Linearisierungsverfahren eingesetzt, das die Nichtlinearität der Messstrecke ausgleicht und sich vorzugsweise auf eine Linearisierungstabelle mit Korrekturfaktoren stützt.

Bei der Demodulation des Gleichstromanteils können sowohl Korrekturfaktoren aus einer Linearisierungstabelle als auch Interpolationsverfahren für Zwischenwerte eingesetzt werden. Auf diese Weise ist eine sehr genaue Bestimmung des Gleichstromanteils über den gesamten Messbereich möglich.

Die Erstellung der Linearisierungstabelle erfolgt im Kalibriermodus der Messvorrichtung, indem eine automatisierte Kalibrierprozedur durchlaufen wird. Im Kalibriermodus, der ausgewählt werden sollte, wenn der flexible Messring keinen Stromleiter umschließt, werden alle in einem Testsignalgenerator vordefinierten Gleichstrompegel von einer hochgenauen Stromquelle bereitgestellt und nacheinander für jeweils eine Analyseperiode auf die Magnetisierungsspule geschaltet. Die Auswertung des resultierenden Magnetkern-Sondensignals führt bei den einzelnen Gleichstrompegeln zu spezifischen Korrekturfaktoren, die in der Linearisierungstabelle gespeichert werden.

Um die Anzahl der Stützstellen und damit die Kalibrierzeit (Stützstellenzahl * Analyseperiode) gering zu halten, wird vorgeschlagen, für Messwerte, die zwischen den Stützstellen der Linearisierungskurve liegen, geeignete Interpolationsverfahren einzusetzen. Dabei ist neben der einfachsten linearen Interpolation zwischen benachbarten Stützstellen auch eine nichtlineare Interpolation mit beispielsweise höhergradigen Polynomen denkbar.

Ausführungsbeispiel

Nachfolgend wird die Erfindung anhand von Ausführungsbeispielen und einigen Zeichnungen näher erläutert. Dabei zeigt in schematischer Darstellung

**Figur 1** eine erste Ausführungsform der erfindungsgemäßen Vorrichtung zur präzisen Messung eines Gleichstromanteils in einem Mischstrom unter Einsatz einer Rogowski-Sonde mit netzperiodengestützter Integrator-Einheit und einer Magnetkern-Sonde mit superparamagnetischem Kern,

**Figur 2** eine zweite Ausführungsform der erfindungsgemäßen Vorrichtung zur Messung eines Gleichstromanteils in einem Mischstrom unter Einsatz nur einer Sonde mit superparamagnetischem Kern,

**Figur 3** eine Ausführungsform einer Demodulator-Einheit zur Ermittlung des Gleichstromanteils durch die spektrale Auswertung des Magnetkern-Sondensignals, zum Einsatz in den erfindungsgemäßen Vorrichtungen gemäß Figur 1 oder 2,

**Figur 4** eine Ausführungsform einer Kompensations-Einheit zur Bildung des aus Anregungssignal und Kompensierstrom zusammengesetzten Magnetisierstromsignals, zum Einsatz in den erfindungsgemäßen Vorrichtungen gemäß Figur 1 oder 2,

**Figur 5** eine Ausführungsform einer Integrator-Einheit zum Einsatz in der erfindungsgemäßen Vorrichtung gemäß Figur 1, und

**Figur 6** eine Ausführungsform einer Phasenregelschleife zum Einsatz in den erfindungsgemäßen Vorrichtungen gemäß Figur 1 oder 2.

**Figur 7** den zeitlichen Verlauf eines Mischstroms in den erfindungsgemäßen Vorrichtungen gemäß Figur 1 und Figur 2, und deren Messfehlerkurven bei konstantem Gleichstromanteil.

**Figur 8** eine graphische Beschreibung des Signalflusses in den erfindungsgemäßen Vorrichtungen gemäß Figur 1 und Figur 2.

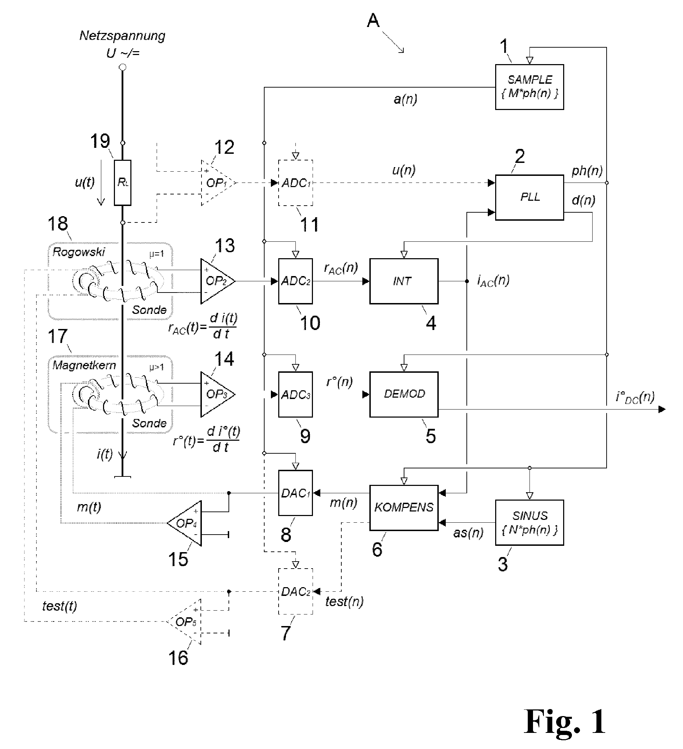

**Figur 1** zeigt schematisch eine erste Ausführungsform der erfindungsgemäßen Vorrichtung zur Messung eines Gleichstromanteils in einem Mischstrom, der insgesamt die Bezugsziffer A zugeordnet ist.

Am Lastwiderstand 19 entsteht der Spannungsabfall $u(t)$. Der Trenn-Verstärker 12 dient zur Ankopplung dieses Spannungsabfalls und der Analog-Digital-Wandler 11 generiert daraus das Spannungssignal $u(n)$.

Die hochgenaue Ermittlung des Wechselstromsignals $i_{AC}(n)$ aus dem Messspulensignal $r_{AC}(t)$ der Rogowski-Sonde 18 erfolgt über den Verstärker 13 und den Analog-Digital-Wandler 10 in der netzperiodengestützten Integrator-Einheit 4. Ein wesentlicher Baustein ist die Phasenregelschleife 2, die für die gesamte Vorrichtung A die Steuersignale zur Synchronisation der einzelnen Signalverarbeitungsmodule bereitstellt. Hierzu steuert die Phasenregelschleife 2 den Oszillator 1, der das Abtastsignal $a(n)$ generiert.

Die Gleichstromerfassung über die Magnetkern-Sonde macht das Anregungssignal *as(n)* erforderlich, das der Oszillator 3 zur Verfügung stellt. Im Ausführungsbeispiel wird das Anregungssignal *as(n)* in der Kompensations-Einheit 6 mit dem aus dem festgestellten Wechselstromsignal $i_{AC}(n)$ ermittelten Kompensierstrom zusammengefasst und als Magnetisierstromsignal *m(n)* über den Digital-Analog-Wandler 8 und die Stromquelle 15 auf die Magnetisierungsspule der Magnetkern-Sonde 17 geführt. Durch den Einsatz der Phasenregelschleife 2 sind die Phasen des Anregungssignals und des Kompensierstroms mit der Phase des Wechselstromanteils im Mischstrom synchronisiert. Schließlich kann aus dem Messspulensignal $r^0(t)$ der Magnetkern-Sonde 17 das Gleichstromsignal $i^0_{DC}(n)$ über den Verstärker 14 und den Analog-Digital-Wandler 9 in der Demodulator-Einheit 5 hochgenau ermittelt werden.

Im Kalibriermodus der gesamten Vorrichtung A stellt die Kompensations-Einheit 6 das Testsignal *test(n)* bereit und speist dieses über den Digital-Analog-Wandler 7 und die Stromquelle 16 in die Testspule der Rogowski-Sonde 18 ein.

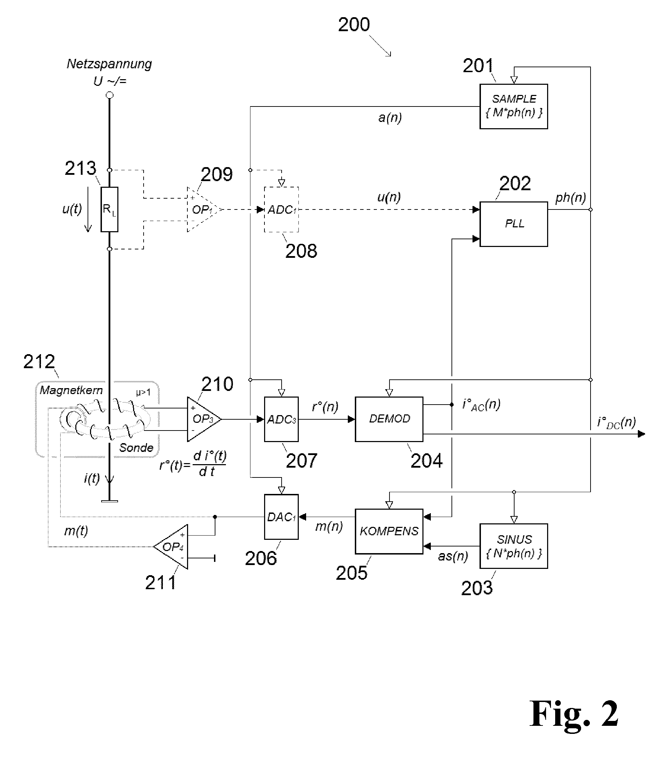

In **Figur 2** ist schematisch eine zweite Ausführungsform der erfindungsgemäßen Vorrichtung 200 dargestellt, die eine Messung des Gleichstromanteils in einem Mischstrom mit einer einzelnen Magnetkern-Sonde ermöglicht.

Am Lastwiderstand 213 entsteht der Spannungsabfall *u(t)*. Der Trenn-Verstärker 209 dient zur Ankopplung dieses Spannungsabfalls und der Analog-Digital-Wandler 208 generiert daraus das Spannungssignal *u(n)*.

Ein wesentlicher Baustein in diesem Ausführungsbeispiel ist die Phasenregelschleife 202, die für die gesamte Vorrichtung 200 die Steuersignale zur Synchronisation der einzelnen Signalverarbeitungsmodule bereitstellt. Hierzu steuert die Phasenregelschleife 202 den Oszillator 201, der das Abtastsignal *a(n)* generiert.

Die Gleichstromerfassung über die Magnetkern-Sonde macht das Anregungssignal *as(n)* erforderlich, das der Oszillator 203 zur Verfügung stellt. Im Ausführungsbeispiel wird das Anregungssignal *as(n)* durch die Kompensations-Einheit 205 mit einem Teil, des in der Demodulator-Einheit 204 festgestellten Wechselstromsignals $i^0_{AC}(n)$ zusammengefasst und als Magnetisierstromsignal *m(n)* über den Digital-Analog-Wandler 206 und die Stromquelle 211 auf die Magnetisierungsspule der Magnetkern-Sonde 212 geführt. Schließlich kann aus dem Messspulensignal $r^0(t)$ der Magnetkern-Sonde 212 das Gleichstromsignal $i^0_{DC}(n)$ über den Verstärker 210 und den Analog-Digital-Wandler 207 in der Demodulator-Einheit 204 ermittelt werden.

Das Wechselstromsignal $i^0_{AC}(n)$ wird ebenfalls aus dem Messspulensignal $r^0(t)$ der Magnetkern-Sonde 212 über die Modulkette bestehend aus Verstärker 210, Analog-Digital-Wandler 207 und Demodulator-Einheit 204 ermittelt.

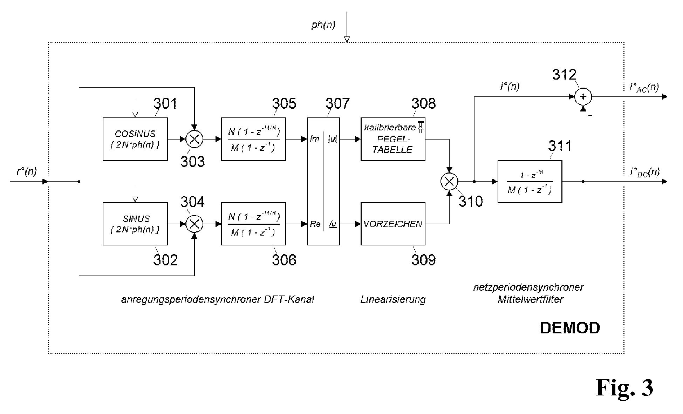

**Figur 3** zeigt in schematischer Darstellung eine Ausführungsform der Demodulator-Einheit 5 in Figur 1, wie auch der Demodulator-Einheit 204 in Figur 2. Bei der Demodulator-Einheit 5 in Figur 1 wird der Ausgang für das Wechselstromsignal $i^0_{AC}(n)$ nicht genutzt. Diese in Figur 1 und Figur 2 eingesetzte Demodulator-Einheit mit der Bezeichnung *"DEMOD"* generiert das Gleichstromsignal $i^0_{DC}(n)$ durch die spektrale Auswertung des Magnetkern-Sondensignals $r^0(n)$ auf der zweiten Harmonischen des Anregungssignals.

Das Phasensignal *ph(n)* entspricht dabei dem Differentialquotienten der Frequenz (Anregungssignal-Frequenz = $N *$ Wechselstrom-Frequenz) des Anregungssignals *as(n)*.

Zur spektralen Auswertung des Magnetkern-Sondensignals $r^0(n)$ wird die **D**iskrete **F**ourier-**T**ransformation auf der Basis des Phasensignals *ph(n)* für eine singuläre Kanalfrequenz ausgeführt. Ein DFT-Kanal mit parametrierbarer Kanalfrequenz, Rechteck-Analysefenster und adaptierbarer Fensterlänge ist auch als Frequenzlupe bekannt. Wesentliche Bausteine des DFT-Kanals sind die beiden Oszillatoren 301 und 302 zur Bereitstellung des komplexen Kanalamplitudenwertes (auf der zweiten Harmonischen des Anregungssignals), die beiden Multiplizierer 303 und 304 zur Mischung des Magnetkern-Sondensignalwertes $r^0(n)$ mit dem komplexen Kanalamplitudenwert, und die beiden Mittelwertfilter 305 und 306 (mit der Filterlänge *M/N*) zur Realisierung des anregungsperiodensynchronen Analysefensters.

Der DFT-Kanal analysiert den Momentanwert des Magnetkern-Sondensignals $r^0(n)$ auf der zweiten Harmonischen des Anregungssignals und transformiert das Analyseergebnis auf 0 Hz, sodass ein komplexer Wert entsteht, der den bewerteten Momentanwert des Mischstromsignals $i^0(n)$ beschreibt. Nach der Koordinatenwandlung im Baustein 307 wird die nichtlineare, durch die Magnetisierungskurve vorgegebene Amplitudenbewertung über die Linearisierungstabelle 308 korrigiert und der komplexe Ausgangswert des DFT-Kanals mit Hilfe des Vorzeichendetektors 309 und des Multiplizierers 310 in einen Wert mit Betrag und Vorzeichen umgewandelt. Dieser Wert ist ein momentaner Eingangswert des Filters 311, der als netzperiodensynchroner Mittelwertfilter mit der Filterlänge *M* den Gleichstromsignalwert $i^0_{DC}(n)$ bestimmt und am Ausgang der Demodulator-Einheit zur Verfügung stellt. Der Wechselstromsignalwert $i^0_{AC}(n)$ entsteht am Ausgang des Addierers 312 aus der Differenz zwischen Mischstromsignalwert $i^0(n)$ und Gleichstromsignalwert $i^0_{DC}(n)$.

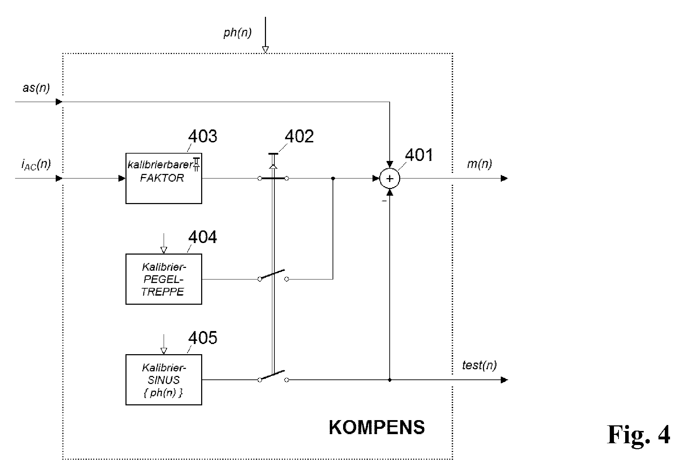

**Figur 4** zeigt in schematischer Darstellung eine Ausführungsform der Kompensations-Einheit 6 aus Figur 1. Auch die Kompensations-Einheit 205 aus Figur 2 ist entsprechend ausgebildet mit der Maßgabe, dass bei dieser Ausführungsform der Testsignalgenerator nicht verwendet wird. Diese in Figur 1 und in Figur 2 eingesetzte Kompensations-Einheit mit der Kurzbezeichnung *"KOMPENS"* besteht im Wesentlichen aus dem Übertrager 403, dem Schalter 402 und dem Addierer 401. Sie weist neben den beiden Eingängen für das Anregungssignal *as(n)* und das Wechselstromsignal $i_{AC}(n)$ auch einen Steuersignaleingang für das Phasensignal *ph(n)* auf.

Im normalen Betriebsmodus der Messvorrichtung wird das Anregungssignal *as(n)* mit dem im Übertrager 403 gewichteten Wechselstromsignal $i_{AC}(n)$ durch den Addierer 401 zu dem Magnetisierstromsignal *m(n)* zusammengefasst und auf einen Ausgang der Kompensations-Einheit geführt.

Wenn durch den Schalter 402 der Kalibriermodus der Messvorrichtung aktiviert ist, dann fasst der Addierer 401 stattdessen das Ausgangssignal des Testsignalgenerators 404 mit dem Anregungssignal as(n) zum Magnetisierstromsignal m(n) zusammen. Außerdem wird diesem Magnetisierstromsignal m(n) über den Addierer 401 das Teststromsignal test(n) vom Testsignalgenerator 405 hinzugefügt und dieses Teststromsignal test(n) an einem zweiten Ausgang der KompensationsEinheit (für die in Figur 1 beschriebene Ausführungsform der Messvorrichtung) zur Verfügung gestellt. Die Testsignalgeneratoren 404, 405 und der Schalter 402 sowie Testspule der Rogowski-Sonde (nicht in Figur 4 dargestellt) bilden ein Kalibrier-Modul im Sinne der Erfindung.

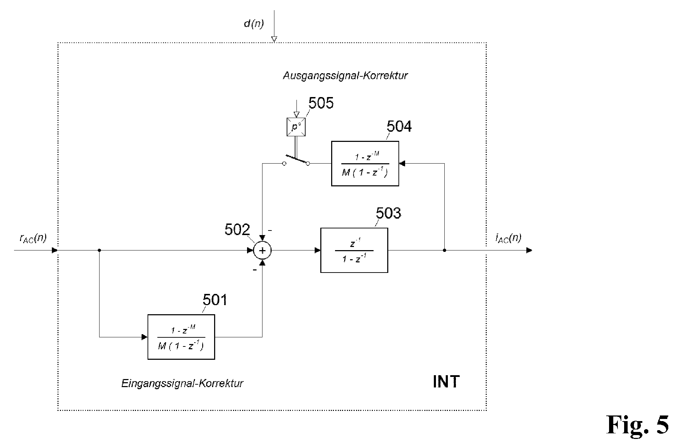

**Figur 5** zeigt in schematischer Darstellung eine Ausführungsform der Integrator-Einheit 4 aus Figur 1. Diese in Figur 1 eingesetzte Integrator-Einheit mit der Kurzbezeichnung "INT" umfasst neben dem Integrator 503 einen ersten netzperiodensynchronen Mittelwertfilter 501 und einen zweiten netzperiodensynchronen Mittelwertfilter 504. Sie weist neben einem Eingang für das Rogowski-Sondensignal $r_{AC}(n)$ auch einen Eingang für das Steuersignal d(n) auf. Am Ausgang dieser Integrator-Einheit steht das regenerierte Wechselstromsignal $i_{AC}(n)$ zur Verfügung.Der Mittelwertfilter 501 führt eine Eingangssignal-Korrektur durch, indem er zu jedem aktuellen Abtastzeitpunkt n die letzten M Abtastwerte des zeitdiskreten Rogowski-Sondensignals $r_{AC}(n)$ zu einem Gleichsignalwert zusammenfasst und im Addierer 502 vom aktuellen Abtastwert des Rogowski-Sondensignals $r_{AC}(n)$ subtrahiert. Der hierdurch erhaltene gleichsignalfreie Signalwert wird mit dem Integrator 503 integriert, sodass schließlich das Wechselstromsignal $i_{AC}(n)$ entsteht. Der dritte Eingang des Addierers 502 ermöglicht die Ausgangssignal-Korrektur des integrierten Wertes zum Startzeitpunkt der Netzperiode.

Der Mittelwertfilter 504 fasst die jeweils letzten M Abtastwerte des zeitdiskreten Wechselstromsignals $i_{AC}(n)$ zu einem aktuellen Gleichsignalwert zusammen, den der Schalter 505 jeweils zum Startzeitpunkt p° einer Netzperiode mit negiertem Vorzeichen (über den Addierer 502) auf den Eingang des Integrators 503 zurückführt, sodass der Gleichsignalanteil im Ausgangssignal $i_{AC}(n)$ kompensiert ist.

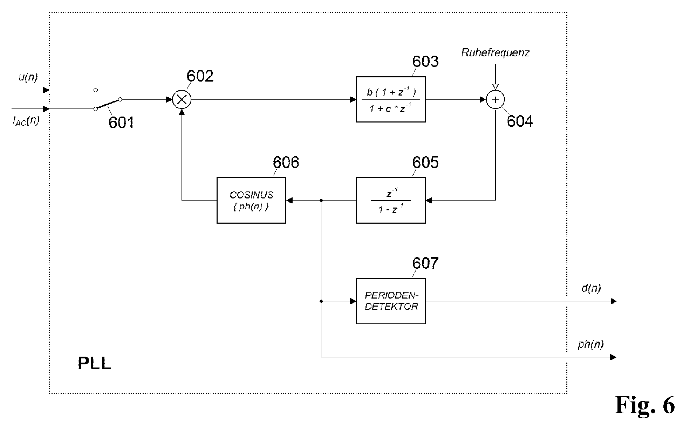

**Figur 6** zeigt in schematischer Darstellung eine Ausführungsform der digitalen Phasenregelschleife 2 aus Figur 1, wie auch der digitalen Phasenregelschleife 202 aus Figur 2. Diese in Figur 1 und in Figur 2 eingesetzte Phasenregelschleife mit der Kurzbezeichnung *"PLL"* wird zur Synchronisation nachgeordneter Signalverarbeitungsmodule eingesetzt. Wesentlicher Baustein dieser *PLL* ist der steuerbare Oszillator 606, dessen harmonisches Ausgangssignal in dem Multiplizierer 602 mit einem äußeren Referenzsignal gemischt wird, das abhängig von der Stellung des Schalters 601 entweder dem Spannungssignal u(n) oder einem Wechselstromsignal $i_{AC}(n)$ entspricht. Das Mischergebnis enthält die Regelabweichung, die über die *PLL*-Bausteine Schleifenfilter 603, Addierer 604 und Integrator 605 auf den Oszillator 606 so zurückgekoppelt wird, dass Phasenlage und Frequenz des Oszillatorsignals in dieser Phasenregelschleife zweiter Ordnung vom äußeren Referenzsignal bestimmt werden. Dabei akkumuliert der Integrator 605 die Regelabweichung und die Ruhefrequenz zum Phasensignal ph(n). Schließlich stehen am Ausgang der Phasenregelschleife ein zeitdiskretes Phasensignal ph(n) und durch den Perioden-Detektor 607 ein zeitdiskretes Detektorsignal d(n) mit einem Unterabtastzeitpunkt p pro Netzperiode für die Synchronisation nachgeordneter Signalverarbeitungsmodule zur Verfügung.

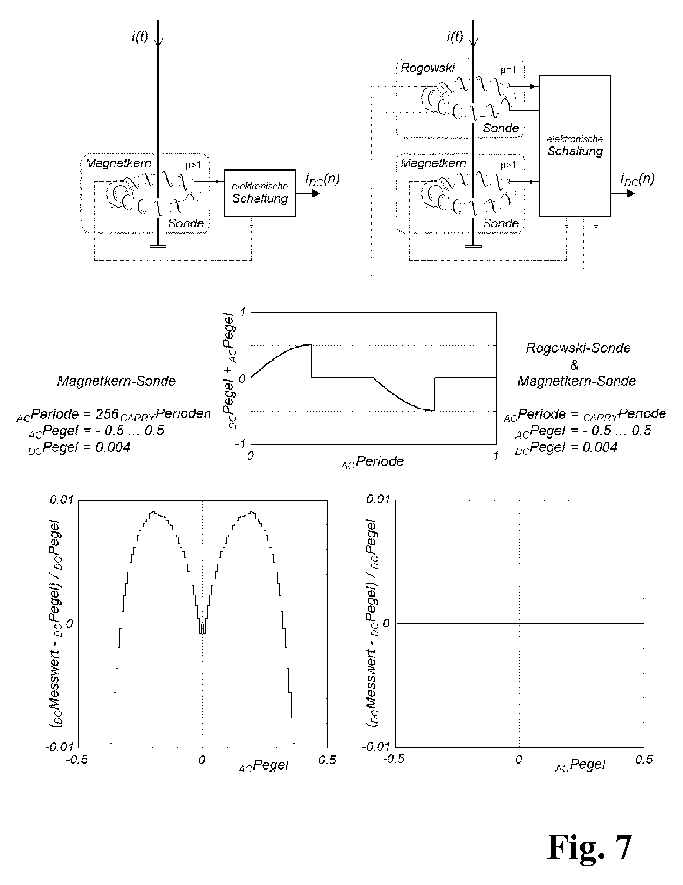

In **Figur 7** sind die Messfehlerkurven der beiden Messvorrichtungen gemäß Figur 2 und Figur 1 am Beispiel eines Mischstromsignals gegenübergestellt, das sich aus einem Gleichstromanteil und einem symmetrischen Wechselstromanteil zusammensetzt. Die Stromsequenzen für die Messfehlerkurven können in einem Stromversorgungsnetz bei einer Wechselspannung mit abgestuften Effektivwerten an einer phasenanschnittgesteuerten ohmschen Last entstehen. Da die Messvorrichtung nach Figur 1 den Wechselstromanteil separat erfasst und diesen in jeder Analyseperiode vollständig kompensiert, kann die Frequenz des Anregungssignals mit der Frequenz des Wechselstromanteils im Mischstrom gleichgesetzt ($_{AC}PERIODE = {}_{CARRY}PERIODE$) werden.

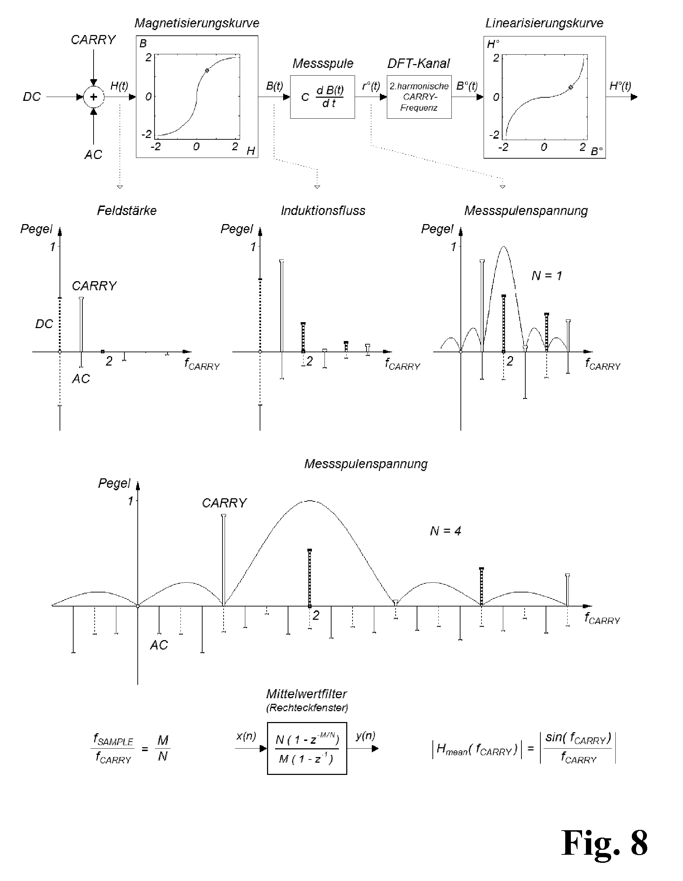

In **Figur 8** sind die wesentlichen Komponenten der Messvorrichtung zur graphischen Darstellung des Messprinzips aufgeführt. Nach der Erfassung des Gleichstromanteils über eine superparamagnetische Magnetkern-Sonde erfolgt die Demodulation des induzierten Magnetkern-Messspulensignals auf der zweiten Harmonischen des Anregungssignals durch einen DFT-Kanal mit Rechteckfenster. Beim Einsatz von periodensynchronen Mittelwertfiltern liegen die harmonischen Signalkomponenten eines Wechselstromanteils mit nicht sinusförmigem Signalverlauf optimal auf den Nulldurchgängen des Amplitudengangs der Übertragungsfunktion $H_{mean}(f_{CARRY}) = sin(f_{CARRY}) / f_{CARRY}$ des (mit der Filterlänge $M/N = f_{SAMPLE}/f_{CARRY}$ abgestimmten) Mittelwertfilters $H_{mean}(Z^{-1}) = N(1 - z^{-MIN}) / (M(1 - z^{-1}))$, wenn der Synthesefaktor N=1 ist.

Die beiden in Figur 8 dargestellten Amplitudengänge verdeutlichen, dass eine relativ genaue Messung des Gleichstromanteils in einem Mischstrom nicht nur durch einen großen Frequenzabstand zwischen Wechselstrom-Frequenz und Anregungssignal-Frequenz (N = *Anregungssignal-Frequenz / Wechselstrom-Frequenz >> 1*) möglich wird, sondern besonders exakt durch eine Kompensation des Wechselstromanteils im Messpfad zu erreichen ist. Wird der Wechselstromanteil (beispielsweise im Induktionsfluss des Sondenkerns) vollständig kompensiert, dann kann die exakte Messung des Gleichstromanteils auch mit dem Synthesefaktor N=1 erfolgen.

Liste der Bezugzeichen und Abkürzungen für Figur 1

| Bezugzeichen / Abkürzung | Bezeichnung | Funktion / Zweck |
|---|---|---|
| 1 | Oszillator [ $SAMPLE\{M*ph(n)\}$ ] | Erzeugung des Abtastsignals $a(n)$ |
| 2 | Phasenregelschleife [ $PLL$ ] | Generierung der Steuersignale $ph(n)$, $d(n)$ |
| 3 | Oszillator [ $CARRY\{N*ph(n)\}$ ] | Erzeugung des Anregungssignals $as(n)$ |
| 4 | Integrator-Einheit [ $INT$ ] | Regenerierung des Wechselstromsignals $i_{AC}(n)$ |
| 5 | Demodulator-Einheit [ $DEMOD$ ] | Regenerierung des Gleichstromsignals $i^0_{DC}(n)$ |
| 6 | Kompensations-Einheit [ $KOMPENS$ ] | Bildung des Magnetisierstromsignals $m(n)$, Generierung des Teststromsignals $test(n)$ |
| 7 | Digital-Analog-Wandler [ $DAC_2$ ] | Wandlung des Teststromsignals $test(n)$ |
| 8 | Digital-Analog-Wandler [ $DAC_1$ ] | Wandlung des Magnetisierstromsignals $m(n)$ |
| 9 | Analog-Digital-Wandler [ $ADC_3$ ] | Wandlung zum Magnetkern-Sondensignal $i^0(n)$ |
| 10 | Analog-Digital-Wandler [ $ADC_2$ ] | Wandlung zum Rogowski-Sondensignal $r_{AC}(n)$ |
| 11 | Analog-Digital-Wandler [ $ADC_1$ ] | Wandlung zum Spannungssignal $u(n)$ |
| 12 | Trenn-Verstärker [ $OP1$ ] | Ankopplung des Spannungsabfalls $u(t)$ |
| 13 | Verstärker [ $OP2$ ] | Anpassung des Rogowski-Messspulensignals $r_{AC}(t)$ |
| 14 | Verstärker [ $OP_3$ ] | Anpassung des Magnetkern-Messspulensignals $r^0(t)$ |
| 15 | Stromquelle [ $OP4$ ] | Einspeisung des Magnetisierstroms $m(t)$ |
| 16 | Stromquelle [ $OP_5$ ] | Einspeisung des Teststroms $test(t)$ |
| 17 | Stromwandler [ $Magnetkern\text{-}Sonde$ ] | Kontrolle des Induktionsflusses |
| 18 | Stromwandler [ $Rogowski\text{-}Sonde$ ] | Kontrolle der magnetischen Feldstärke |
| 19 | Lastwiderstand [ $R_L$ ] | Abgriff des Spannungsabfalls $u(t)$ |
| $i(t)$ | Mischstrom im Stromleiter | Eingang_1 [ $Rogowski\text{-}Sonde$ ] Eingang_1 [ $Magnetkern\text{-}Sonde$ ] |
| $test(t)$ | Teststrom in Testspule | Eingang_2 [ $Rogowski\text{-}Sonde$ ] |
| $m(t)$ | Magnetisierstrom in Magnetisierungsspule | Eingang_2 [ $Magnetkern\text{-}Sonde$ ] |
| $r_{AC}(t)$ | Messspulensignal der Rogowski-Sonde | Ausgang [ $Rogowski\text{-}Sonde$ ] |
| $r^0(t)$ | Messspulensignal der Magnetkern-Sonde | Ausgang [ $Magnetkern\text{-}Sonde$ ] |
| $u(t)$ | Spannungsabfall an $R_L$ | Ausgang [ $R_L$ ] |
| $ph(n)$ | Phasensignal | Ausgang_1 [ $PLL$ ] |
| $d(n)$ | Detektorsignal | Ausgang_2 [ $PLL$ ] |

**EP 2 905 627 B1**

(fortgesetzt)

| Bezugszeichen / Abkürzung | Bezeichnung | Funktion / Zweck |
|---|---|---|
| $a(n)$ | Abtastsignal | Ausgang [ $SAMPLE\{M*ph(n)\}$ ] |
| $as(n)$ | Anregungssignal | Ausgang [ $CARRY\{N*ph(n)\}$ ] |
| $m(n)$ | Magnetisierstromsignal | Ausgang [ KOMPENS ] |
| $test(n)$ | Teststromsignal | Ausgang [ KOMPENS ] |
| $u(n)$ | Spannungssignal | Ausgang [ ADC1 ] |
| $r_{AC}(n)$ | Rogowski-Sondensignal | Ausgang [ $ADC_2$ ] |
| $r^0(n)$ | Magnetkern-Sondensignal | Ausgang [ $ADC_3$ ] |
| $i_{Ac}(n)$ | Wechselstromsignal | Ausgang [ INT ] |
| $i^0_{DC}(n)$ | Gleichstromsignal | Ausgang [ DEMOD ] |

Liste der Bezugszeichen und Abkürzungen für Figur 2

| Bezugszeichen / Abkürzung | Bezeichnung | Funktion / Zweck |
|---|---|---|
| 201 | Oszillator [ $SAMPLE\{M*ph(n)\}$ ] | Erzeugung des Abtastsignals $a(n)$ |
| 202 | Phasenregelschleife [ PLL ] | Generierung der Steuersignale $ph(n)$, $d(n)$ |
| 203 | Oszillator [ $CARRY\{N*ph(n)\}$ ] | Erzeugung des Anregungssignals $as(n)$ |
| 204 | Demodulator-Einheit [ DEMOD ] | Bildung des Gleichstromsignals $i^0_{DC}(n)$, Bildung des Wechselstromsignals $i^0_{AC}(n)$ |
| 205 | Kompensations-Einheit [ KOMPENS ] | Bildung des Magnetisierstromsignals $m(n)$ |
| 206 | Digital-Analog-Wandler [ $DAC_1$ ] | Wandlung des Magnetisierstromsignals $m(n)$ |
| 207 | Analog-Digital-Wandler [ $ADC_3$ ] | Wandlung zum Magnetkern-Sondensignal $r^0(n)$ |
| 208 | Analog-Digital-Wandler [ $ADC_1$ ] | Wandlung zum Spannungssignal $u(n)$ |
| 209 | Trenn-Verstärker [ $OP_1$ ] | Ankopplung des Spannungsabfalls $u(t)$ |
| 210 | Verstärker [ $OP_3$ ] | Anpassung des Magnetkern-Messspulensignals $r^0(t)$ |
| 211 | Stromquelle [ $OP_4$ ] | Einspeisung des Magnetisierstroms $m(t)$ |
| 212 | Stromwandler [ Magnetkern-Sonde ] | Kontrolle des Induktionsflusses |
| 213 | Lastwiderstand [ $R_L$ ] | Abgriff des Spannungsabfalls $u(t)$ |
| $i(t)$ | Mischstrom im Stromleiter | Eingang_1 [ Magnetkern-Sonde ] |
| $m(t)$ | Magnetisierstrom in Magnetisierungsspule | Eingang_2 [ Magnetkern-Sonde ] |
| $r^0(t)$ | Messspulensignal der Magnetkern-Sonde | Ausgang [ Magnetkern-Sonde ] |
| $u(t)$ | Spannungsabfall an $R_L$ | Ausgang [ $R_L$ ] |

(fortgesetzt)

| Bezugszeichen / Abkürzung | Bezeichnung | Funktion / Zweck |
|---|---|---|
| $r^0(t)$ | Messspulensignal der Magnetkern-Sonde | Ausgang [ Magnetkern-Sonde ] |
| $ph(n)$ | Phasensignal | Ausgang_1 [ PLL ] |
| $d(n)$ | Detektorsignal | Ausgang_2 [ PLL ] |
| $a(n)$ | Abtastsignal | Ausgang [ SAMPLE{M*ph(n)} ] |
| $as(n)$ | Anregungssignal | Ausgang [ CARRY{N*ph(n)} ] |
| $m(n)$ | Magnetisierstromsignal | Ausgang [ KOMPENS ] |
| $u(n)$ | Spannungssignal | Ausgang [ ADC1 ] |
| $r^0(n)$ | Magnetkern-Spulensignal | Ausgang [ $ADC_3$ ] |
| $i^0_{DC}(n)$ | Gleichstromsignal | Ausgang_1 [ DEMOD ] |
| $i^0_{AC}(n)$ | Wechselstromsignal | Ausgang_2 [ DEMOD ] |

Liste der Bezugszeichen und Abkürzungen für Figur 3

| Bezugszeichen / Abkürzung | Bezeichnung | Funktion / Zweck |
|---|---|---|
| 301 | Oszillator [ COSINUS{ 2N*ph(n)} ] | Generierung des Realteils des DFT-Kanalamplitudenwertes |
| 302 | Oszillator [ SINUS(2N*ph(n))} ] | Generierung des Imaginärteils des DFT-Kanalamplitudenwertes |
| 303 | Multiplizierer [ * ] | Mischung Magnetkern-Sondensignalwert $r^0(n)$ mit dem Realteil des DFT-Kanalamplitudenwertes |
| 304 | Multiplizierer [ * ] | Mischung Magnetkern-Sondensignalwertes $r^0(n)$ mit Imaginärteil des DFT-Kanalamplitudenwertes |
| 305 | DFT-Real-Kanal-Filter [ $H_{meanANREGUNGSPERIODE}(z^{-1}) = N(1 - z^{-M/N}) / (M (1 - z^{-1}))$ ] | anregungsperiodensynchrones Analysefenster für den Realteil des DFT-Kanals |
| 306 | DFT-Imag-Kanal-Filter [ $H_{meanANREGUNGSPERIODE}(z^{-1}) = N (1 - z^{-M/N}) / (M (1 - z^{-1}))$ ] | anregungsperiodensynchrones Analysefenster für den Imaginärteil des DFT-Kanals |
| 307 | Koordinatenwandler [ Real & Imag / Magnitude & Angle ] | Bestimmung der Signalamplitude des Mischstromsignals $i^0(n)$ |
| 308 | Linearisierungstabelle [kalibrierbare PEGEL-TABELLE] | Linearisierung der Amplitudenwerte des Mischstromsignals $i^0(n)$ |
| 309 | Vorzeichendetektor [ VORZEICHEN ] | Vorzeichen des Mischstromsignals $i^0(n)$ |
| 310 | Multiplizierer [ * ] | Verknüpfung von Amplitude und Vorzeichen des Mischstromsignals $i^0(n)$ |
| 311 | Netzperioden-Filter [ $H_{meanNETZPERIODE}(z^{-1}) = (1 - z^{-M}) / (M (1 - z^{-1}))$ ] | netzperiodensynchroner Mittelwertfilter zur Bestimmung des Gleichstromsignals $i^0_{DC}(n)$ |
| 312 | Addierer [ + - ] | Rekonstruktion des Wechselstromsignals $i^0_{AC}(n)$ aus Mischstromsignal $i^0(n)$ und Gleichstromsignal $i^0_{DC}(n)$ |
| $ph(n)$ | Phasensignal | Steuer-Eingang [ DEMOD ] |

(fortgesetzt)

| Bezugszeichen / Abkürzung | Bezeichnung | Funktion / Zweck |
|---|---|---|
| $r^0(n)$ | Magnetkern-Sondensignal | Eingang [ *DEMOD* ] |
| $i^0_{DC}(n)$ | Gleichstromsignal | Ausgang_1 [ *DEMOD* ] |
| $i^0_{AC}(n)$ | Wechselstromsignal | Ausgang_2 [ *DEMOD* ] |

Liste der Bezugszeichen und Abkürzungen für Figur 4

| Bezugszeichen / Abkürzung | Bezeichnung | Funktion / Zweck |
|---|---|---|
| 401 | Addierer [ + + - ] | Bildung des Magnetisierstromsignals $m(n)$ |
| 402 | Schalter [ /_ ] | Manuelle Aktivierung Betriebsmodus "Kalibrieren Vorrichtung" |
| 403 | Übertrager [ *kalibrierbarer FAKTOR* ] | Bildung des Kompensierstroms |
| 404 | Testsignalgenerator [ *Kalibrier-PEGEL-TREPPE* ] | Generierung von Gleichstrompegeln im Magnetisierstromsignal $m(n)$ zur Kalibrierung der Linearisierungstabelle [ kalibrierbare *PEGEL-TABELLE* ] |
| 405 | Testsignalgenerator [ *Kalibrier-SINUS {ph(n)}* ] | Generierung des Teststromsignals *test(n)* zur Kalibrierung des Übertragungsfaktors [ *kalibrierbarer FAKTOR* ] |
| $ph(n)$ | Phasensignal | Steuer-Eingang [ *KOMPENS* ] |
| $as(n)$ | Anregungssignal | Eingang_1 [ *KOMPENS* ] |
| $i_{Ac}(n)$ | Wechselstromsignal | Eingang_2 [ *KOMPENS]* |
| $m(n)$ | Magnetisierstromsignal | Ausgang_1 [ *KOMPENS* ] |
| *test(n)* | Teststromsignal | Ausgang_2 [ *KOMPENS* ] |

Liste der Bezugszeichen und Abkürzungen für Figur 5

| Bezugszeichen / Abkürzung | Bezeichnung | Funktion / Zweck |
|---|---|---|
| 501 | Mean-Filter [ $H_{meanIN}(z^{-1}) = (1 - z^{-M}) / (M (1 - z^{-1}))$] | Ermittlung des Gleichanteils im Rogowski-Sondensignal $r_{AC}(n)$ aus $M$ Abtastwerten pro Wechselstromperiode |
| 502 | Addierer [ - + - ] | Korrektur des Gleichanteils im Rogowski-Sondensignal $r_{AC}(n)$ sowie Korrektur des Integrator-Startwertes |
| 503 | Integrator [ $H_{integrator}(z^{-1}) = z^{-1} / (1 - z^{-1})$ ] | Regenerierung des Wechselstromsignals $i_{AC}(n)$ |
| 504 | Mean-Filter [ $H_{meanOUT}(z^{-1}) = (1 - z^{-M}) / (M(1 - z^{-1}))$ ] | Ermittlung des Gleichanteils im Wechselstromsignal $i_{AC}(n)$ aus M Abtastwerten pro Wechselstromperiode |
| 505 | Schalter [ /_ ] | Zuschaltung des Integrator-Startwertes zum Startzeitpunkt $p°$ der Netzperiode |
| $d(n)$ | Detektorsignal | Steuer-Eingang [ *INT* ] |
| $r_{AC}(n)$ | Rogowski-Sondensignal | Eingang [ *INT* ] |
| $i_{Ac}(n)$ | Wechselstromsignal | Ausgang [ *INT* ] |

Liste der Bezugzeichen und Abkürzungen für Figur 6

| Bezugszeichen / Abkürzung | Bezeichnung | Funktion / Zweck |
|---|---|---|
| 601 | Schalter [ /_ ] | Auswahl des Referenzsignals $u(n)$ oder $i_{AC}(n)$ |
| 602 | Multiplizierer [ * ] | Mischung von Referenzsignal und Oszillatorsignal |
| 603 | Schleifenfilter [ $H_{schleifenfilter}(z^{-1}) = b\,(1 + z^{-1}) / (1 + c * z^{-1})$ ] | Koeffizienten $b$ und $c$ für den optimal gedämpften PhasenRegelkreis zweiter Ordnung |
| 604 | Addierer [ + + ] | Bildung des Momentanfrequenzwertes |
| 605 | Integrator [ $H_{integrator}(z^{-1}) = z^{-1} / (1 - z^{-1})$ ] | Akkumulation der Momentanfrequenzwerte zum Phasensignal $ph(n)$ |
| 606 | Oszillator [ $COSINUS\{ph(n)\}$ ] | Generierung des Oszillatorsignals |
| 607 | Detektor [ PERIODEN-DETEKTOR ] | Bestimmung des Startzeitpunktes $p°$ der Signalperiode |
| $u(n)$ | Spannungssignal | Eingang_2 [ PLL ] |
| $i_{Ac}(n)$ | Wechselstromsignal | Eingang_1 [ PLL ] |
| $d(n)$ | Detektorsignal | Ausgang_2 [ PLL ] |
| $ph(n)$ | Phasensignal | Ausgang_1 [ PLL ] |

**Patentansprüche**

1. Vorrichtung (A; 200) zur kontaktlosen Messung des Gleichstromanteils in einem Mischstrom eines Stromleiters, aufweisend eine Magnetkern-Sonde (17; 212) zur Erfassung des Wechselstromanteils und des Gleichstromanteils im Mischstrom, einen Oszillator (3; 203) zur Generierung eines Anregungssignals, sowie eine Kompensations-Einheit (6; 205) zur Erzeugung eines Kompensierstroms zur induktiven Kompensation des Wechselstromanteils in der Magnetkern-Sonde (17; 212), wobei das Anregungssignal und der Kompensierstrom auf die Magnetkern-Sonde (17; 212) geführt sind, **dadurch gekennzeichnet, dass** eine Phasenregelschleife (2; 202) vorgesehen ist, die dazu eingerichtet ist, die Phasen des Anregungssignals und des Kompensierstroms mit der Phase des Wechselstromanteils im Mischstrom zu synchronisieren.

2. Vorrichtung nach Anspruch 1, **dadurch gekennzeichnet, dass** die Magnetkern-Sonde (17; 212) ein Magnetkern-Sondensignal erzeugt, und dass zur Auswertung des Magnetkern-Sondensignals eine Demodulator-Einheit (5; 204) vorgesehen ist.

3. Vorrichtung nach Anspruch 1 oder 2, **dadurch gekennzeichnet, dass** die Magnetkern-Sonde (17; 212) ein nichtlineares Magnetkern-Sondensignal erzeugt, und dass zur Linearisierung des Magnetkern-Sondensignals ein Kalibrier-Modul zur Kalibrierung der Magnetkern-Sonde (17; 212) unter Zugrundelegung einer Linearisierungskurve vorgesehen ist.

4. Vorrichtung nach einem der vorhergehenden Ansprüche, **dadurch gekennzeichnet, dass** zur Erfassung des Wechselstromanteils im Mischstrom eine Rogowski-Sonde (18) mit einer mehrstufigen Filter-und Integrator-Einheit (4) vorgesehen ist, die über die Phasenregelschleife (2) mit der Phase des Wechselstromanteils im Mischstrom synchronisiert ist, und dass ein Ausgangssignal der Filter- und Integrator-Einheit (4) den Kompensierstrom bildet.

5. Vorrichtung nach einem der vorhergehenden Ansprüche, **dadurch gekennzeichnet, dass** ein Signalgenerator (405) zur Erzeugung eines Testsignals vorgesehen ist, und dass die Rogowski-Sonde (18) neben einer Messspule eine Testspule zur Einspeisung des Testsignals aufweist.

6. Vorrichtung nach Anspruch 2 oder nach Anspruch 2 und 3, **dadurch gekennzeichnet, dass** die Demodulator-Einheit (5; 204) einen ersten Signalverarbeitungspfad zur Demodulation des Gleichstromanteils und einen zweiten Signalverarbeitungspfad für die Gewinnung des Wechselstromanteils aus dem Mischstrom aufweist.

7. Vorrichtung nach einem der vorhergehenden Ansprüche, **dadurch gekennzeichnet, dass** die Magnetkern-Sonde (17; 212) eine Magnetisierungsspule zur Einspeisung des Anregungsignals und des Kompensierstroms aufweist.

8. Vorrichtung nach einem der vorhergehenden Ansprüche, **dadurch gekennzeichnet, dass** die Magnetkern-Sonde (17; 212) einen zu einem flexiblen Messring formbaren Spulenkörper aus einem superparamagnetischen Material aufweist.

9. Vorrichtung nach einem der vorhergehenden Ansprüche, **dadurch gekennzeichnet, dass** zur Erfassung des Induktionsflusses in der Magnetkern-Sonde (17; 212) eine Magnetkern-Messspule vorgesehen ist.

10. Vorrichtung nach einem der vorhergehenden Ansprüche, **dadurch gekennzeichnet, dass** zur Extraktion des Gleichstromanteils ein signal-angepasstes phasensynchrones Mittelwertfilter (305; 306; 311) vorgesehen ist.

11. Vorrichtung nach einem der vorhergehenden Ansprüche, **dadurch gekennzeichnet, dass** das Anregungssignal eine Anregungssignal-Frequenz und der Wechselstromanteil eine Wechselstrom-Frequenz aufweist, und dass die Anregungssignal-Frequenz einem ganzzahlig Vielfachen der Wechselstrom-Frequenz entspricht, wobei vorzugsweise die Anregungssignal-Frequenz der Wechselstrom-Frequenz entspricht.

12. Verfahren zur kontaktlosen Messung des Gleichstromanteils in einem Mischstrom eines Stromleiters, umfassend die Verfahrensschritte:

   (a) Generieren eines Anregungssignals für eine Magnetkern-Sonde (17; 212),
   (b) Erfassen des Wechselstromanteils und des Gleichstromanteils im Mischstrom mit der Magnetkern-Sonde (17; 212),
   (c) Erzeugen eines Kompensierstroms zur induktiven Kompensation des Wechselstromanteils in der Magnetkern-Sonde (17; 212), und
   (d) Ermitteln des Gleichstromanteils,
   **dadurch gekennzeichnet, dass** die Phasen des Anregungssignals und des Kompensierstroms mit der Phase des Wechselstromanteils im Mischstrom über eine Phasenregelschleife (2; 202) synchronisiert werden.

13. Verfahren nach Anspruch 12, **dadurch gekennzeichnet, dass** der Wechselstromanteil und der Gleichstromanteil mittels einer Magnetkern-Sonde (17; 212) mit einem superparamagnetischen Kern erfasst wird, und dass nach dem Erfassen des Wechselstromanteils und des Gleichstromanteils gemäß Verfahrensschritt (b) in einem ersten Signalverarbeitungspfad einer Demodulator-Einheit (5; 204) der Gleichstromanteil und in einem zweiten Signalverarbeitungspfad der Demodulator-Einheit (5; 204) der Wechselstromanteil gewonnen wird.

14. Verfahren nach Anspruch 12, **dadurch gekennzeichnet, dass** der Gleichstromanteil mittels einer Magnetkern-Sonde (17; 212) mit einem superparamagnetischen Kern erfasst wird, und dass der Wechselstromanteil mittels einer Rogowski-Sonde (18) mit einer mehrstufigen Filter- und Integrator-Einheit (4) erfasst wird, die über die Phasenregelschleife (2; 202) mit der Phase des Wechselstromanteils im Mischstrom synchronisiert ist, wobei die Filter- und Integrator-Einheit (4) als Ausgangssignal den Kompensierstrom erzeugt.

15. Verfahren nach einem der vorhergehenden Ansprüche 12 bis 14, **dadurch gekennzeichnet, dass** die Magnetkern-Sonde (17; 212) ein nichtlineares Magnetkern-Sondensignal erzeugt, und dass zur Korrektur des nichtlinearen Magnetkern-Sondensignals eine Linearisierungskurve eingesetzt wird, die durch Ermittlung von Stützstellen und gegebenenfalls nachfolgender Interpolation gewonnen ist.

## Claims

1. Apparatus (A; 200) for contactless measurement of the direct current component in a mixed current of a current conductor, comprising a magnetic core probe (17; 212) for detecting the alternating current component and the direct current component in the mixed current, an oscillator (3; 203) for generating an excitation signal and a compensation unit (6; 205) for generating a compensation current for inductive compensation of the alternating current component in the magnetic core probe (17; 212), whereby the excitation signal and the compensation current are led on the magnetic core probe (17; 212), **characterized in that** a phase locked loop (2; 202) is provided which synchronizes the phase of the excitation signal and the compensation current with the phase of the alternating current component in the mixed current.

**2.** Device according to claim 1, **characterized in that** the magnetic core probe (17; 212) generates a magnetic core probe signal, and that for evaluation of the magnetic core probe signal, a demodulator unit (5; 204) is provided.

**3.** Device according to claim 1 or 2, **characterized in that** the magnetic core probe (17; 212) generates a non-linear magnetic core probe signal and **in that** for linearizing the magnetic core probe signal, a calibration module for calibrating the magnetic core probe (17; 212) is provided on the basis of a linearization curve.

**4.** Device according to one of the preceding claims, **characterized in that** for detection of the alternating current component in the mixed current a Rogowski sensor (18) is provided, said Rogowski sensor (18) having a multi-stage filter and integrator unit (4), that is synchronized via the phase locked loop (2) with the phase of the alternating current component in the mixed current, and wherein an output signal of the filter and integrator unit (4) forms the compensation current.

**5.** Device according to one of the preceding claims, **characterized in that** a signal generator (405) is provided for generating a test signal, and **in that** the Rogowski sensor (18) comprises a test coil for feeding the test signal in addition to a measuring coil.

**6.** Device according to claim 2 or according to claims 2 and 3, **characterized in that** the demodulator unit (5; 204) comprises a first signal processing path for demodulation of the direct current component and a second signal processing path for the extraction of the alternating current component from the mixed current.

**7.** Device according to one of the preceding claims, **characterized in that** the magnetic core probe (17; 212) has a magnetization coil for feeding the excitation signal and the compensation current.

**8.** Device according to one of the preceding claims, **characterized in that** the magnetic core probe (17; 212) comprises a coil body formable into a flexible measuring ring made of a superparamagnetic material.

**9.** Device according to one of the preceding claims, **characterized in that** a magnetic core measuring coil is provided for detection of the magnetic flux in the magnetic core probe (17; 212).

**10.** Device according to one of the preceding claims, **characterized in that** a matched phase synchronous averaging filter (305; 306; 311) is provided for extraction of the direct current component.

**11.** Device according to one of the preceding claims, **characterized in that** the excitation signal has an excitation signal frequency and the alternating current component has an alternating current frequency, and that the excitation signal frequency corresponds to an integer multiples of the alternating current frequency, and preferably the excitation signal frequency corresponds to the alternating current frequency.

**12.** A method for contactless measurement of the direct current component in a mixed current of a current conductor, comprising the steps of:

(a) generating an excitation signal for a magnetic core-probe (17; 212)
(b) detecting the alternating current component and the direct current component in the mixed current with the magnetic core probe (17; 212),
(c) generating a compensation current for inductive compensation of the alternating current component in the magnetic core probe (17; 212), and
(d) determining the direct current component,
**characterized in that** the phases of the excitation signal and the compensation current are synchronized with the phase of the alternating current component in the mixed current by a phase locked loop (2; 202).

**13.** The method according to claim 12, **characterized in that** the alternating current component and the direct current component are detected by means of a magnetic core probe (17; 212) using a super paramagnetic core, and that after the detection of the alternating current component and the direct current component the direct current component is produced in accordance with process step (b) in a first signal processing path of a demodulator unit (5; 204), and the alternating current component is produced in a second signal processing path of the demodulator unit (5; 204).

**14.** The method according to claim 12, **characterized in that** the direct current component is detected by means of a magnetic core probe (17, 212) with a super paramagnetic core, and that the alternating current component is detected by means of a Rogowski sensor (18) having a multi-stage filter and integrator unit (4), that is synchronized with the phase of the alternating current component in the mixed current via the phase locked loop (2; 202), whereby the filter and integrator unit (4) generates the compensation current as an output signal.

15. The method according to any one of the preceding claims 12 to 14, **characterized in that** the magnetic core probe (17; 212) generates a non-linear magnetic core probe signal and **in that** for correction of the nonlinear magnetic core probe signal, a linearization curve is used that is obtained by determining nodes and optionally subsequent interpolation.

**Revendications**

1. Dispositif (A ; 200) pour la mesure sans contact de la composante en courant continu dans un courant mixte d'un conducteur, présentant une sonde à noyau magnétique (17 ; 212) pour capter la composante en courant alternatif et en courant continu dans le courant mixte d'un oscillateur (3 ; 203) pour la génération d'un signal d'excitation, ainsi qu'une unité de compensation (6 ; 205) pour la génération d'un courant de compensation pour compenser inductivement la composante en courant alternatif dans la sonde à noyau magnétique (17 ; 212), le signal d'excitation et le courant de compensation étant amenés à la sonde à noyau magnétique (17 ; 212), **caractérisé en ce qu'**il est prévu une boucle à verrouillage de phase (2 ; 202) conçue pour synchroniser les phases du signal d'excitation et du courant de compensation à la phase de la composante en courant alternatif dans le courant mixte.

2. Dispositif selon la revendication 1, **caractérisé en ce que** la sonde à noyau magnétique (17 ; 212) génère un signal de sonde à noyau magnétique et qu'il est prévu une unité de démodulation (5 ; 204) pour l'analyse du signal de sonde à noyau magnétique.

3. Dispositif selon la revendication 1 ou 2, **caractérisé en ce que** la sonde à noyau magnétique (17 ; 212) génère un signal de sonde à noyau magnétique non linéaire et qu'il est prévu un module de calibrage de la sonde à noyau magnétique (17 ; 212) pour la linéarisation du signal de sonde à noyau magnétique en se basant sur une courbe de linéarisation.

4. Dispositif selon l'une des revendications précédentes, **caractérisé en ce que** pour la détection de la composante en courant alternatif dans le courant mixte, il est prévu une sonde de Rogowski (18), qui est munie d'une unité d'intégration et de filtrage à plusieurs niveaux (4) qui est synchronisée par la boucle à verrouillage de phase (2) à la phase de la composante en courant alternatif dans le courant mixte et qu'un signal de sortie de l'unité d'intégration et de filtrage (4) forme le courant de compensation.

5. Dispositif selon l'une des revendications précédentes, **caractérisé en ce qu'**il est prévu un générateur de signal (405) pour la génération d'un signal test et **en ce que** la sonde de Rogowski (18) présente, outre une bobine de mesure, une bobine test pour l'alimentation du signal test.

6. Dispositif selon la revendication 2 ou la revendication 2 et 3, **caractérisé en ce que** l'unité de démodulation (5 ; 204) présente un premier trajet de traitement de signal pour la démodulation de la composante en courant alternatif et un second trajet de traitement de signal pour l'obtention de la composante en courant alternatif dans le courant mixte.

7. Dispositif selon l'une des revendications précédentes, **caractérisé en ce que** la sonde à noyau magnétique (17 ; 212) présente une bobine de magnétisation pour l'alimentation du signal d'excitation et du courant de compensation.

8. Dispositif selon l'une des revendications précédentes, **caractérisé en ce que** la sonde à noyau magnétique (17 ; 212) présente un corps de bobines déformable en un anneau de mesure flexible dans un matériau superparamagnétique.

9. Dispositif selon l'une des revendications précédentes, **caractérisé en ce qu'**il est prévu une bobine de mesure à noyau magnétique.

10. Dispositif selon l'une des revendications précédentes, **caractérisé en ce qu'**il est prévu pour l'extraction de la composante en courant continu un filtre de moyennage (305 ; 306 ; 311) synchronisé en phase adapté au signal.

**11.** Dispositif selon l'une des revendications précédentes, **caractérisé en ce que** le signal d'excitation présente une fréquence de signal d'excitation et la composante en courant alternatif une fréquence de courant alternatif et que la fréquence de signal d'excitation correspond à un multiple entier de la fréquence de courant alternatif, la fréquence de signal d'excitation correspondant de préférence à la fréquence de courant alternatif.

**12.** Procédé pour la mesure sans contact de la composante en courant alternatif dans un courant mixte d'un conducteur de courant comprenant les étapes suivantes :

(a) génération d'un signal d'excitation pour une sonde à noyau magnétique (17 ; 212).
(b) détection de la composante en courant alternatif et en courant continu dans le courant mixte avec la sonde à noyau magnétique (17 ; 212).
(c) génération d'un courant de compensation pour la compensation inductive de la composante en courant alternatif dans la sonde à noyau magnétique (17 ; 212), et
(d) détermination de la composante en courant continu,
**caractérisé en ce que** les phases du signal d'excitation et du courant de compensation sont synchronisées avec la phase de la composante en courant alternatif dans le courant mixte par une boucle à verrouillage de phase (2 ; 202).

**13.** Procédé selon la revendication 12, **caractérisé en ce que** la composante en courant alternatif et en courant continu est détectée au moyen d'une sonde à noyau magnétique (17 ; 212) munie d'un noyau superparamagnétique et qu'après la détection de la composante en courant alternatif et courant continu selon l'étape (b) de procédé, la composante en courant alternatif est obtenue dans un premier trajet de traitement de signal d'une unité de démodulateur (5 ; 204) et la composante en courant alternatif dans un second trajet de traitement de signal d'une unité de démodulateur (5 ; 204).

**14.** Procédé selon la revendication 12, **caractérisé en ce que** la composante en courant alternatif est détectée au moyen d'une sonde à noyau magnétique (17 ; 212) et que la composante en courant alternatif est détectée au moyen d'une sonde de Rogowski (18) munie d'une unité d'intégration et de filtrage (4), qui est synchronisée avec la phase de la composante en courant alternatif par la boucle à verrouillage de phase (2 ; 202), l'unité d'intégration et de filtrage (4) générant le courant de compensation en tant que signal de sortie.

**15.** Procédé selon l'une des revendications précédentes 12 à 14, **caractérisé en ce que** la sonde à noyau magnétique (17 ; 212) génère un signal non linéaire de noyau magnétique et **en ce que** pour la correction du signal de sonde à noyau magnétique non linéaire, on utilise une courbe de linéarisation, qui est obtenue par détermination de points nodaux et éventuellement d'une interpolation subséquente.

A

1

SAMPLE
{ M*ph(n) }

a(n)

Netzspannung
U ~/=

19

u(t)

$R_L$

12

OP₁

11

ADC₁

u(n)

2

PLL

ph(n)

d(n)

18

Rogowski

μ=1

Sonde

13

OP₂

10

ADC₂

$r_{AC}(n)$

4

INT

$i_{AC}(n)$

$r_{AC}(t) = \dfrac{d\,i(t)}{d\,t}$

17

Magnetkern

μ>1

Sonde

14

OP₃

9

ADC₃

r°(n)

5

DEMOD

$i°_{DC}(n)$

$r°(t) = \dfrac{d\,i°(t)}{d\,t}$

i(t)

m(t)

15

OP₄

8

DAC₁

m(n)

6

KOMPENS

3

SINUS
{ N*ph(n) }

as(n)

test(t)

16

OP₅

7

DAC₂

test(n)

**Fig. 1**

Fig. 2

**Fig. 3**

23

**Fig. 4**

$d(n)$

Ausgangssignal-Korrektur

505

$p°$

504

$$\frac{1 - z^{-M}}{M\,(\,1 - z^{-1}\,)}$$

502

503

$-$

$$\frac{z^{-1}}{1 - z^{-1}}$$

$r_{AC}(n)$

$i_{AC}(n)$

$+$

$-$

501

$$\frac{1 - z^{-M}}{M\,(\,1 - z^{-1}\,)}$$

Eingangssignal-Korrektur

INT

**Fig. 5**

Fig. 6

26

**Fig. 7**

Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20120038360 A1
- DE 102007013634 A1
- DE 202012012649 U1